# EUROPEAN PATENT APPLICATION

(11) **EP 4 572 555 A1**
(43) Date of publication of application: **18.06.2025**
(21) Application number: 24198295.8
(22) Date of filing: 03.09.2024
(51) Int. Cl.: H10B 12/00

(54) **INTEGRATED CIRCUIT DEVICE**

(30) Priority: 15.12.2023 KR 20230183046
(71) Applicant: Samsung Electronics Co., Ltd., Gyeonggi-do, 16677 (KR)
(72) Inventor: HWANG, Inyeong, 16677 Suwon-si (KR); SHIN, Seokho, 16677 Suwon-si (KR)
(74) Representative: Marks & Clerk LLP

(57) **Abstract**

An integrated circuit device includes a substrate having a cell array area and a peripheral circuit area including a core area, a plurality of cell conductive patterns at a reference vertical level in the cell array area on the substrate, wiring patterns at the reference vertical level in the peripheral circuit area, a capacitor structure including lower electrodes respectively connected to the cell conductive patterns in the cell array area, a middle wiring pattern at a first vertical level in the peripheral circuit area, a cell protective insulating liner covering a top surface of each of the cell conductive patterns in the cell array area, and a peripheral protective insulating liner covering a surface of the middle wiring pattern in the peripheral circuit area, wherein at least a portion of the peripheral protective insulating liner has a thickness greater than a thickness of the cell protective insulating liner.

## Description

### BACKGROUND

The inventive concepts relate to integrated circuit (IC) devices, and more particularly, to IC devices including a cell array area and a peripheral circuit area adjacent to the cell array area.

Recent developments in electronic technology have resulted in the rapid downscaling of IC devices. This has led to a reduction of a feature size of IC devices and an increase in the number of wirings required in each of a cell array area and a peripheral circuit area including a core area adjacent to the cell array area. Accordingly, it is necessary to develop a new structure that may ensure a required number of wirings without increasing a planar area of a wiring structure and also ensure the electrical reliability of unit devices located in each of the cell array area and the peripheral circuit area.

### SUMMARY

The inventive concepts provide an integrated circuit (IC) device which may ensure a required number of wirings without the need to increase a planar area of a wiring structure even when a pattern density and a required number of wirings are increased in each of a cell array area with a reduced area due to downscaling and a cell array area and a peripheral circuit area including a core area adjacent to the cell array area, and which has a structure capable of ensuring the electrical reliability of unit devices arranged in each of the cell array area and the peripheral circuit area.

According to some aspects of the inventive concepts, there is provided an IC device including a substrate having a cell array area and a peripheral circuit area including a core area, the peripheral circuit area adjacent to the cell array area; a plurality of cell conductive patterns in the cell array area on the substrate, the plurality of cell conductive patterns at a reference vertical level; a plurality of lower wiring patterns in the peripheral circuit area, the plurality of lower wiring patterns at the reference vertical level; a capacitor structure in the cell array area, the capacitor structure including a plurality of lower electrodes connected to the plurality of cell conductive patterns, respectively; a middle wiring pattern in the peripheral circuit area, the middle wiring pattern at a first vertical level that is farther from the substrate than the reference vertical level and closer to the substrate than a vertical level of an uppermost surface of the capacitor structure; a cell protective insulating liner in the cell array area, the cell protective insulating liner covering a top surface of each of the plurality of cell conductive patterns ; and a peripheral protective insulating liner in the peripheral circuit area, the peripheral protective insulating liner covering a surface of the middle wiring pattern, wherein at least a portion of the peripheral protective insulating liner has a thickness greater than a thickness of the cell protective insulating liner.

According to another aspect of the inventive concept, there is provided an IC device including a substrate having a cell array area and a peripheral circuit area including a core area, the peripheral circuit area adjacent to the cell array area; a bit line on the substrate in the cell array area; a cell contact plug apart from the bit line in a lateral direction in the cell array area, the cell contact plugs being connected to a cell active area of the substrate; a conductive landing pad contacting the cell contact plug, the conductive landing pad on the cell contact plug in the cell array area, the conductive landing pad being at a reference vertical level on the substrate; an isolated insulating pattern in the cell array area, the isolated insulating pattern covering sidewalls of the conductive landing pad; a plurality of lower wiring patterns in the peripheral circuit area, the plurality of lower wiring patterns at the reference vertical level; a capacitor structure in the cell array area, the capacitor structure including a lower electrode connected to the conductive landing pad; a plurality of middle wiring patterns in the peripheral circuit area, the plurality of middle wiring patterns at a first vertical level that is farther from the substrate than the reference vertical level and closer to the substrate than a vertical level of an uppermost surface of the capacitor structure, the plurality of middle wiring patterns being apart from each other in the lateral direction; a cell protective insulating liner covering a top surface of each of the conductive landing pad and the isolated insulating pattern; and a peripheral protective insulating liner covering a surface of each of the plurality of middle wiring patterns, wherein at least a portion of the peripheral protective insulating liner has a thickness greater than a thickness of the cell protective insulating liner.

According to another aspect of the inventive concept, there is provided an IC device including a substrate having a cell array area and a peripheral circuit area including a core area, the peripheral circuit area adjacent to the cell array area; a bit line on the substrate in the cell array area; a cell contact plug apart from the bit line in a lateral direction in the cell array area, the cell contact plug being connected to a cell active area of the substrate; a conductive landing pad contacting the cell contact plug, the conductive landing pad on the cell contact plug in the cell array area, the conductive landing pad being arranged at a reference vertical level on the substrate; an isolated insulating pattern in the cell array area, the isolated insulating pattern surrounding sidewalls of the conductive landing pad; a cell protective insulating liner in the cell array area, the cell protective insulating liner covering a top surface of each of the conductive landing pad and the isolated insulating pattern; a capacitor structure including a lower electrode, a dielectric film, and an upper electrode in the cell array area, the lower electrode passing through the cell protective insulating liner and contacting the conductive landing pad, the dielectric film contacting the lower electrode and the cell protective insulating liner, the upper electrode covering the lower electrode with the dielectric film between the upper electrode and the lower electrode; a plurality of lower wiring patterns in the peripheral circuit area, the plurality of lower wiring patterns at the reference vertical level; a middle wiring pattern in the peripheral circuit area, the middle wiring pattern at a first vertical level, which is farther from the substrate than the reference vertical level and closer to the substrate than a vertical level of an uppermost surface of the upper electrode; a peripheral protective insulating liner in the peripheral circuit area, the peripheral protective insulating liner covering a surface of the middle wiring pattern; an upper wiring pattern at a second vertical level in the peripheral circuit area, the second vertical level is farther from the substrate than the vertical level of the uppermost surface of the upper electrode; and an upper contact plug extending in a vertical direction between the middle wiring pattern and the upper wiring pattern, the upper contact plug passing through the peripheral protective insulating liner and contacting the middle wiring pattern, wherein at least a portion of the peripheral protective insulating liner has a thickness greater than a thickness of the cell protective insulating liner.

At least some of the above and other features of the invention are set out in the claims.

### BRIEF DESCRIPTION OF THE DRAWINGS

Example embodiments will be more clearly understood from the following detailed description taken in conjunction with the accompanying drawings in which:
FIG. 1 is a block diagram of a configuration of an integrated circuit (IC) device according to some example embodiments;
FIG. 2 is a diagram for explaining the arrangement of an IC device according to some example embodiments;
FIG. 3 illustrates a plan layout for explaining main components of a cell array area included in an IC device according to some example embodiments;
FIG. 4 is a cross-sectional view of an IC device according to some example embodiments;
FIG. 5 is an enlarged cross-sectional view of portion "EX1" of FIG. 4;
FIG. 6 is a cross-sectional view of an IC device according to some example embodiments;
FIG. 7 is an enlarged cross-sectional view of portion "EX2" of FIG. 6;
FIGS. 8A to 8L and 9A to 9O are cross-sectional views showing a process sequence of a method of manufacturing an IC device, according to some example embodiments; and
FIGS. 10A to 10D are cross-sectional views showing a process sequence of a method of manufacturing an IC device, according to some example embodiments.

### DETAILED DESCRIPTION

Hereinafter, some example embodiments will be described in detail with reference to the accompanying drawings. The same reference numerals are used to denote the same elements in the drawings, and repeated descriptions thereof are omitted.

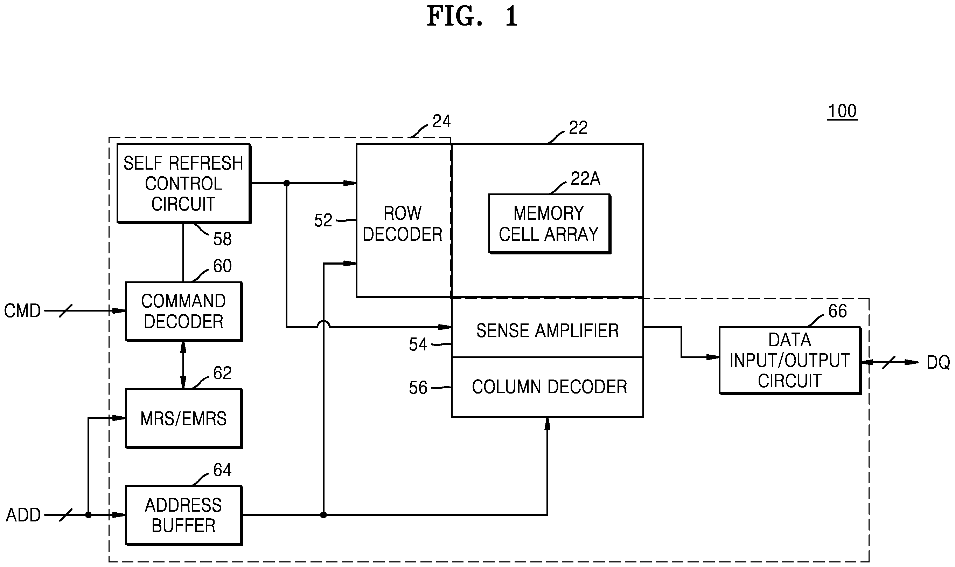

FIG. 1 is a block diagram of an integrated circuit (IC) device 100 according to some example embodiments.

Referring to FIG. 1, the IC device 100 may include a first region 22 and a second region 24. The first region 22 may be a memory cell area of a dynamic random-access memory (DRAM) device, and the second region 24 may include a region in which peripheral circuits of the DRAM device are formed and a core area and be hereinafter referred to as a "peripheral circuit area." The first region 22 may include a memory cell array 22A. The second region 24 may include a row decoder 52, a sense amplifier 54, a column decoder 56, a self-refresh control circuit 58, a command decoder 60, a mode register set/extended mode register set (MRS/EMRS) circuit 62, an address buffer 64, and a data input/output circuit 66. A peripheral circuit (e.g., an inverter chain and an input/output circuit) may be further formed in the second region 24 of FIG. 1.

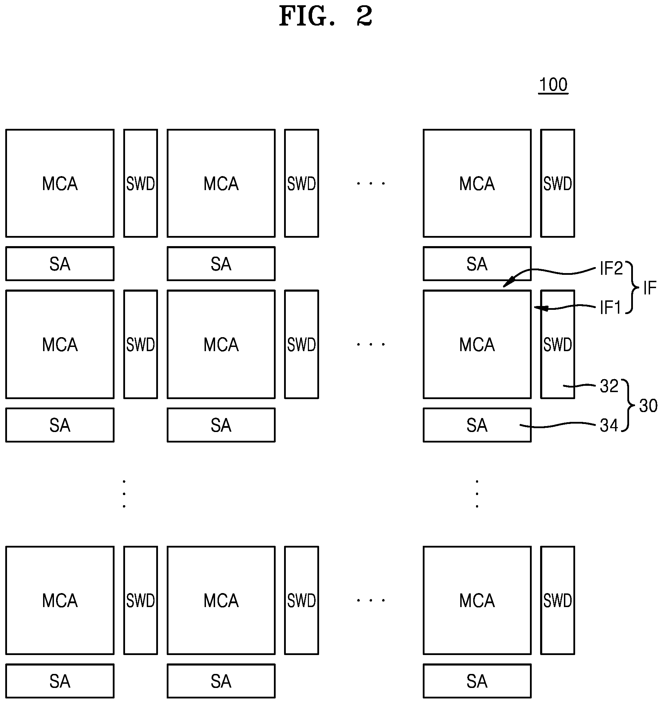

FIG. 2 is a diagram of explaining an example of the arrangement of the IC device 100 shown in FIG. 1.

Referring to FIGS. 1 and 2, the IC device 100 may include a plurality of cell array areas MCA and a core area 30 adjacent to each of the plurality of cell array areas MCA. The plurality of cell array areas MCA may be a portion of the first region 22 shown in FIG. 1. The core area 30 may be a portion of the second region 24 shown in FIG. 1. The core area 30 may include a sub-word line driver region 32 adjacent to one side of the cell array area MCA and a sense amplifier region 34 adjacent to another side of the cell array area MCA. The cell array area MCA may be arranged in the memory cell array 22A described with reference to FIG. 1. In FIG. 2, "SWD" refers to a sub-word line driver located in the core area 30, and the sub-word line driver region 32 may also be referred to as a sub-word line driver region SWD. "SA" refers to a sense amplifier located in the core area 30, and the sense amplifier region 34 may also be referred to as a sense amplifier region SA.

An interface region IF may be between the cell array area MCA and the core area 30. The interface region IF may include a first interface region IF1 between the cell array area MCA and the sub-word line driver region SWD and a second interface region IF2 between the cell array area MCA and the sense amplifier region SA.

The sub-word line driver region SWD may include circuits configured to drive a plurality of word lines arranged in the cell array area MCA. The sense amplifier region SA may include a sense amplifier configured to sense and amplify signals of a plurality of bit lines arranged in the cell array area MCA. In the core area 30, a conjunction block may be at an intersection between the sub-word line driver region SWD and the sense amplifier region SA. In the conjunction block, power drivers and ground drivers configured to drive a bit line sense amplifier may be alternately arranged.

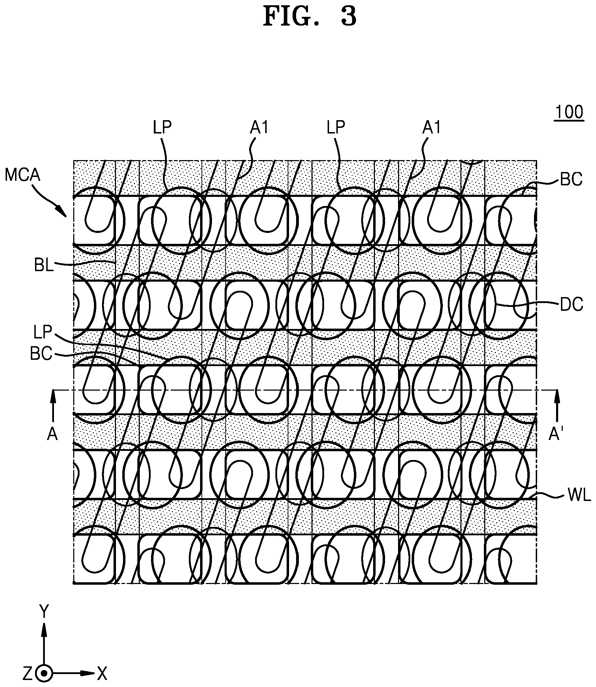

FIG. 3 illustrates a plan layout for explaining main components of the cell array area MCA shown in FIG. 2.

Referring to FIG. 3, the cell array area MCA may include a plurality of cell active areas A1. Each of the plurality of cell active areas A1 may be arranged to have a major axis in an oblique direction with respect to a first lateral direction (an X direction) and a second lateral direction (a Y direction). A plurality of word lines WL may intersect with the plurality of cell active areas A1 and extend parallel to each other in the first lateral direction (the X direction). A plurality of bit lines BL may extend parallel to each other in the second lateral direction (the Y direction) on the plurality of word lines WL. The first lateral direction (the X direction) and the second lateral direction (the Y direction) may be directions that intersect each other. For example, the first lateral direction (the X direction) and the second lateral direction (the Y direction) may be directions that are orthogonal to each other. In this context, a "lateral" direction may be a direction that runs perpendicular to a vertical direction (e.g. Z direction) of the IC device. For instance, a vertical direction may be defined perpendicular to an upper surface of a substrate of the IC device. A lateral (or horizontal) direction may be a direction running parallel to the upper surface of the substrate of the IC device. A feature that is above another feature may be located further along the vertical direction than the other feature (e.g. further from the substrate). It will be appreciated that these directional terms are defined relative to the structure of the IC device, and therefore need not imply any particular orientation of the IC device in use.

The plurality of bit lines BL may be connected to the plurality of cell active areas A1 through direct contacts DC. A plurality of buried contacts BC may be formed between two adjacent ones of the plurality of bit lines BL. A plurality of buried contacts BC may be arranged in a line in the first lateral direction (the X direction) and the second lateral direction (the Y direction). A plurality of conductive landing pads LP may be formed on the plurality of buried contacts BC. The plurality of buried contacts BC and a plurality of conductive landing pads LP may connect a lower electrode (not shown) of a capacitor formed on the plurality of bit lines BL to the cell active area A1. Each of the plurality of conductive landing pads LP may partially overlap a buried contact BC.

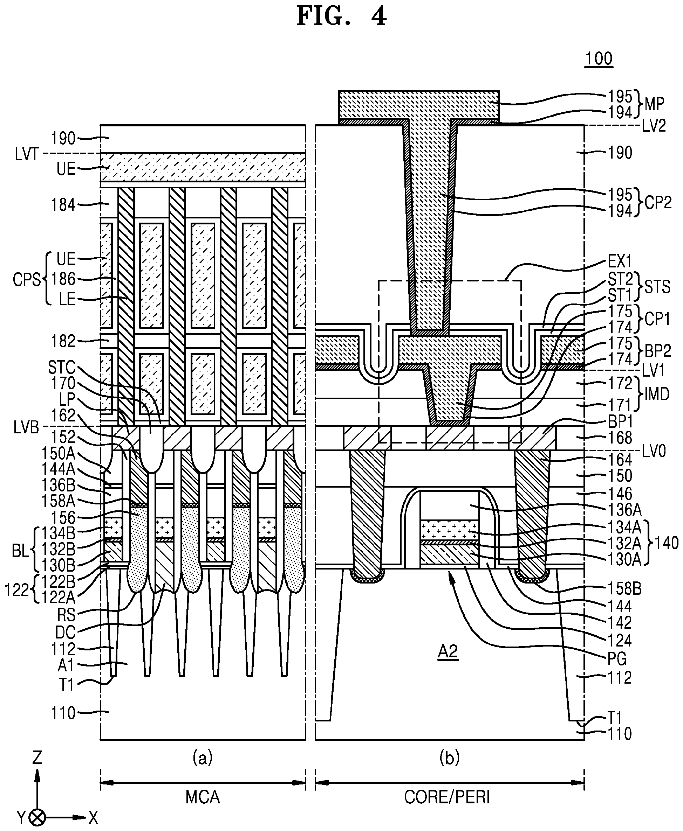

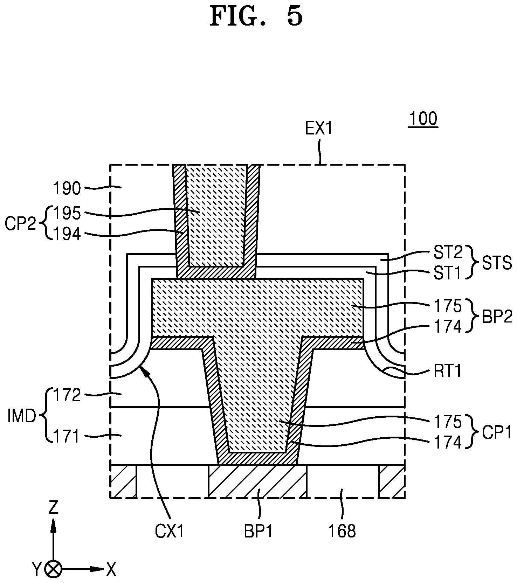

FIG. 4 is a cross-sectional view of an IC device 100 according to some example embodiments. In FIG. 4, (a) shows a cross-sectional view of components in a cell array area MCA of the IC device 100, and (b) shows a cross-sectional view of components in a peripheral circuit area CORE/PERI of the IC device 100. In FIG. 4, (a) illustrates a cross-sectional configuration of a portion corresponding to a cross-section taken along line A - A' of FIG. 3. FIG. 5 is an enlarged cross-sectional view of portion "EX1" of FIG. 4. In FIGS. 4 and 5, the same reference numerals are used to denote the same elements as in FIGS. 1 to 3, and thus, repeated descriptions thereof are omitted.

Referring to FIGS. 4 and 5, the IC device 100 may include a substrate 110. The substrate 110 may include a cell array area MCA and a peripheral circuit area CORE/PERI including a core area 30 adjacent to the cell array area MCA.

The substrate 110 may include silicon, for example, single-crystalline silicon, polycrystalline silicon, or amorphous silicon. In some example embodiments, the substrate 110 may include at least one of germanium (Ge), silicon germanium (SiGe), silicon carbide (SiC), gallium arsenide (GaAs), indium arsenide (InAs), and/or indium phosphide (InP). In some example embodiments, the substrate 110 may include a conductive region, for example, a doped well or a doped structure.

In the cell array area MCA and the peripheral circuit area CORE/PERI, a device isolation film 112 may be at the substrate 110. In the cell array area MCA, a plurality of cell active areas A1 may be defined by the device isolation film 112 in the substrate 110. In the peripheral circuit area CORE/PERI, a peripheral active area A2 may be defined by the device isolation film 112 in the substrate 110. A length of the device isolation film 112 in a vertical direction (Z direction) may vary according to a position of the device isolation film 112 on the substrate 110.

In the cell array area MCA, a buffer film 122 and a plurality of direct contacts DC may be on the substrate 110. The buffer film 122 may include a first insulating film 122A and a second insulating film 122B, which are stacked, for example sequentially stacked, on the substrate 110. Each of the first insulating film 122A and the second insulating film 122B may include an oxide film, a nitride film, or a combination thereof. The plurality of direct contacts DC may be connected to the plurality of cell active areas A1. The plurality of direct contacts DC may include silicon (Si), germanium (Ge), tungsten (W), tungsten nitride (WN), cobalt (Co), nickel (Ni), aluminum (Al), molybdenum (Mo), ruthenium (Ru), titanium (Ti), titanium nitride (TiN), tantalum (Ta), tantalum nitride (TaN), copper (Cu), or a combination thereof, without being limited thereto.

A plurality of bit lines BL may extend in a second lateral direction (Y direction) on the substrate 110 and the plurality of direct contacts DC. Each of the plurality of bit lines BL may be connected to the cell active area A1 through the direct contact DC. Each of the plurality of bit lines BL may include a lower conductive pattern 130B, a middle conductive pattern 132B, and an upper conductive pattern 134B, which are stacked, for example sequentially stacked, on the substrate 110.

The lower conductive pattern 130B may include doped polysilicon. Each of the middle conductive pattern 132B and the upper conductive pattern 134B may include titanium nitride (TiN), titanium silicon nitride (TiSiN), tungsten (W), tungsten silicide, or a combination thereof. In some example embodiments, the middle conductive pattern 132B may include TiN, TiSiN, or a combination thereof, and the upper conductive pattern 134B may include W. A lower insulating capping pattern 136B, an insulating thin film pattern 144A, and an upper insulating capping pattern 150A may be on each of the plurality of bit lines BL to cover, for example sequentially cover, a top surface of each of the bit lines BL. As used herein, the lower insulating capping pattern 136B, the insulating thin film pattern 144A, and the upper insulating capping pattern 150A may be referred to as an insulating capping pattern. Each of the lower insulating capping pattern 136B, the insulating thin film pattern 144A, and the upper insulating capping pattern 150A may include a silicon nitride film.

Sidewalls of each of the plurality of bit lines BL and sidewalls of the insulating capping pattern including the lower insulating capping pattern 136B, the insulating thin film pattern 144A, and the upper insulating capping pattern 150A may be covered by a plurality of insulating spacers 152. The plurality of insulating spacers 152 may extend in the second lateral direction (Y direction) parallel to the plurality of bit lines BL. The plurality of insulating spacers 152 may include an oxide film, a nitride film, air spacers, or a combination thereof. As used herein, the term "air" may refer to space including the atmosphere or other gases that may be present during a manufacturing process. The bit line BL, the lower insulating capping pattern 136B, the insulating thin film pattern 144A, the upper insulating capping pattern 150A, and a pair of insulating spacers 152 covering both sidewalls of each thereof may constitute a bit line structure.

A plurality of lower cell contact plugs 156 may be respectively between the plurality of bit lines BL and arranged in a line in the second lateral direction (Y direction). The plurality of lower cell contact plugs 156 may extend in the vertical direction (Z direction) from the recess space RS formed in the substrate 110. Each of the plurality of lower cell contact plugs 156 may be electrically connected to a selected one of the plurality of cell active areas A1. The plurality of lower cell contact plugs 156 may constitute the plurality of buried contacts BC shown in FIG. 3. Each of the plurality of lower cell contact plugs 156 may be apart from the bit line BL with the insulating spacer 152 therebetween in a first lateral direction (X direction). The plurality of lower cell contact plugs 156 may include doped polysilicon.

A metal silicide film 158A, an upper cell contact plug 162, and a plurality of conductive landing pads LP may be arranged, for example sequentially arranged, on each of the plurality of lower cell contact plugs 156. Each of a plurality of insulating fences may be between two adjacent ones of the plurality of lower cell contact plugs 156 that are arranged in a line in the second lateral direction (Y direction). Each of the plurality of insulating fences may be between two adjacent ones of the plurality of lower cell contact plugs 156 arranged in a line in the second lateral direction (Y direction), between two adjacent ones of a plurality of metal silicide films 158A arranged in a line in the second lateral direction (Y direction), and between two adjacent ones of a plurality of upper cell contact plugs 162 arranged in a line in the second lateral direction (Y direction). The plurality of insulating fences may include a silicon nitride film.

Each of the plurality of metal silicide films 158A, the plurality of upper cell contact plugs 162, and the plurality of conductive landing pads LP may overlap a lower cell contact plug 156 in the vertical direction (Z direction). The plurality of metal silicide films 158A may include cobalt silicide, nickel silicide, or manganese silicide. As used herein, the conductive landing pad LP may also be referred to as a cell conductive pattern.

Each of the plurality of upper cell contact plugs 162 may be connected to the lower cell contact plug 156 through the metal silicide film 158A. Each of the plurality of conductive landing pads LP may be electrically connected to the upper cell contact plug 162 and be electrically connected to the lower cell contact plug 156 through the upper cell contact plug 162 and the metal silicide film 158A. The plurality of upper cell contact plugs 162 may be apart from the lower insulating capping pattern 136B, the insulating thin film pattern 144A, and the upper insulating capping pattern 150A in the first lateral direction (X direction) with the insulating spacers 152 therebetween.

Each of the plurality of upper cell contact plugs 162 and the plurality of conductive landing pads LP may include a metal, a conductive metal nitride, or a combination thereof. In some example embodiments, each of the plurality of upper cell contact plugs 162 and the plurality of conductive landing pads LP may include titanium nitride (TiN), tungsten (W), or a combination thereof. In an example, at least some of the plurality of upper cell contact plugs 162 and the plurality of conductive landing pads LP may include only a TiN film. In another example, at least some of the plurality of upper cell contact plugs 162 and the plurality of conductive landing pads LP may include a stack structure of a TiN barrier film and a W film.

In some example embodiments, the plurality of upper cell contact plugs 162 and the plurality of conductive landing pads LP may include the same metal as each other. In some other example embodiments, the plurality of upper cell contact plugs 162 and the plurality of conductive landing pads LP may include different metals from each other. In an example, each of the plurality of upper cell contact plugs 162 and the plurality of conductive landing pads LP may include a TiN film. In another example, each of the plurality of upper cell contact plugs 162 and the plurality of conductive landing pads LP may include a stack structure of a TiN barrier film and a W film. In still another example, each of the plurality of upper cell contact plugs 162 may include only a TiN film, and each of the plurality of conductive landing pads LP may include a stack structure of a TiN barrier film and a W film. In still another example, each of the plurality of upper cell contact plugs 162 may include a stack structure of a TiN barrier film and a W film, and each of the plurality of conductive landing pads LP may include only a TiN film.

In the cell array area MCA, an isolated insulating pattern 170 may be on a plurality of upper insulating capping patterns 150A, a plurality of insulating spacers 152, and the plurality of upper cell contact plugs 162. The isolated insulating pattern 170 may surround sidewalls of each of the plurality of conductive landing pads LP. The plurality of conductive landing pads LP may be insulated from each other by the isolated insulating pattern 170.

In the cell array area MCA, a top surface of each of the plurality of conductive landing pads LP and the isolated insulating pattern 170 may be covered by a cell protective insulating liner STC. The cell protective insulating liner STC may have a single layer structure including a single insulating liner. The single insulating liner included in the cell protective insulating liner STC may include a silicon boron nitride (SiBN) film, a silicon nitride (SiN) film, a silicon carbonitride (SiCN) film, or a combination thereof, without being limited thereto.

In the cell array area MCA, a capacitor structure CPS may be on the cell protective insulating liner STC. The capacitor structure CPS may include a plurality of lower electrodes LE passing through the cell protective insulating liner STC in the vertical direction (Z direction), a dielectric film 186 in contact with the plurality of lower electrodes LE and the cell protective insulating liner STC, and an upper electrode UE covering the plurality of lower electrodes LE with the dielectric film 186 therebetween. The cell protective insulating liner STC may include portions in contact with the plurality of lower electrodes LE and a portion between a top surface of the isolated insulating pattern 170 and the dielectric film 186 of the capacitor structure CPS. Each of the lower electrodes LE penetrates the cell protective insulating liner STC to contact a corresponding upper cell contact plug 162. As the lower electrodes LE penetrate the cell protective insulating liner STC, the cell protective insulating liner STC covers a portion of the top surface each of the conductive landing pads LP that is not in contact with a lower electrode LE.

Each of the lower electrode LE and the upper electrode UE may include a metal film, a conductive metal oxide film, a conductive metal nitride film, a conductive metal oxynitride film, or a combination thereof. In some example embodiments, each of the lower electrode LE and the upper electrode UE may include niobium (Nb), a Nb oxide, a Nb nitride, a Nb oxynitride, titanium (Ti), a Ti oxide, a Ti nitride, a Ti oxynitride, cobalt (Co), a Co oxide, a Co nitride, a Co oxynitride, tin (Sn), a Sn oxide, a Sn nitride, a Sn oxynitride, or a combination thereof. For example, each of the lower electrode LE and the upper electrode UE may include NbN, TiN, CoN, SnO₂, or a combination thereof. In other example embodiments, each of the lower electrode LE and the upper electrode UE may include tantalum nitride (TaN), titanium aluminum nitride (TiAlN), tantalum aluminum nitride (TaAlN), vanadium (V), vanadium nitride (VN), molybdenum (Mo), molybdenum nitride (MoN), tungsten (W), tungsten nitride (WN), ruthenium (Ru), ruthenium oxide (RuO₂), strontium ruthenium oxide (SrRuO₃), iridium (Ir), iridium oxide (IrO₂), platinum (Pt), platinum oxide (PtO), SrRuO₃ (SRO), (Ba,Sr)RuO₃ (BSRO), CaRuO₃ (CRO), (La,Sr)CoO₃) (LSCo), or a combination thereof. However, a constituent material of each of the lower electrode LE and the upper electrode UE is not limited to the examples described above.

The dielectric film 186 may include a high-k dielectric film. As used herein, the term "high-k dielectric film" refers to a dielectric film having a higher dielectric constant than a silicon oxide film. In some example embodiments, the dielectric film 186 may include a metal oxide including at least one metal selected from hafnium (Hf), zirconium (Zr), aluminum (Al), niobium (Nb), cerium (Ce), lanthanum (La), tantalum (Ta), and/or titanium (Ti). In some example embodiments, the dielectric film 186 may have a single film structure including one high-k dielectric film. In other example embodiments, the dielectric film 186 may have a multilayered structure including a plurality of high-k dielectric films. The high-k dielectric film may include HfO₂, ZrO₂, Al₂O₃, La₂O₃, Ta₂O₃, Nb₂O₅, CeO₂, TiO₂, GeO₂, or a combination thereof, without being limited thereto.

In the capacitor structure CPS, the plurality of lower electrodes LE may be supported by a lower support film 182 and an upper support film 184. Each of the lower support film 182 and the upper support film 184 may include a silicon nitride (SiN) film, a silicon carbonitride (SiCN) film, a silicon boron nitride (SiBN) film, or a combination thereof.

In the peripheral circuit area CORE/PERI, a gate structure PG including a stack structure of a gate dielectric film 124, a gate electrode 140, and a gate capping pattern 136A may be on the substrate 110. Both sidewalls of the gate structure PG may be covered by insulating spacers 142. The gate electrode 140 may include a lower conductive pattern 130A, a middle conductive pattern 132A, and an upper conductive pattern 134A, which are stacked, for example sequentially stacked, on the gate dielectric film 124. The lower conductive pattern 130A may include doped polysilicon. Each of the middle conductive pattern 132A and the upper conductive pattern 134A may include TiN, TiSiN, W, tungsten silicide, or a combination thereof. In some example embodiments, the middle conductive pattern 132A may include TiN, TiSiN, or a combination thereof, and the upper conductive pattern 134A may include W. The gate capping pattern 136A may include a silicon nitride film. The insulating spacer 142 may include a silicon nitride film, a silicon oxide film, or a combination thereof.

In the peripheral circuit area CORE/PERI, the gate structure PG, the insulating spacers 142, and the substrate 110 may be covered by an insulating thin film 144. A lower interlayer insulating film 146 may be on the insulating thin film 144 around the gate structure PG and the insulating spacers 142. The insulating thin film 144 may include a silicon nitride film. The lower interlayer insulating film 146 may include polysilazane, without being limited thereto.

In the peripheral circuit area CORE/PERI, the gate structure PG and the lower interlayer insulating film 146 may be covered by an upper insulating capping layer 150. The upper insulating capping layer 150 may include a silicon nitride film. A plurality of peripheral contact plugs 164 may pass through the upper insulating capping layer 150, the lower interlayer insulating film 146, and the insulating thin film 144 in the vertical direction (Z direction) and be connected to the peripheral active area A2 of the substrate 110. A metal silicide film 158B may be between the plurality of peripheral contact plugs 164 and the peripheral active area A2 of the substrate 110. The metal silicide film 158B may include cobalt silicide, nickel silicide, or manganese silicide, without being limited thereto.

A plurality of lower wiring patterns BP1 may be on the plurality of peripheral contact plugs 164 and the upper insulating capping layer 150. Some of the plurality of lower wiring patterns BP1 may be connected to the peripheral contact plugs 164. The plurality of lower wiring patterns BP1 may be insulated from each other by an insulating pattern 168. The insulating pattern 168 may include a silicon nitride film, a silicon oxide film, or a combination thereof.

The plurality of conductive landing pads LP located in the cell array area MCA and the plurality of lower wiring patterns BP1 arranged in the peripheral circuit area CORE/PERI may be at the same vertical level LV0 on the substrate 110. As used herein, the vertical level LV0 at which the plurality of conductive landing pads LP and the plurality of lower wiring patterns BP1 are located may be referred to as a reference vertical level. As used herein, the term "vertical level" may refer to a distance from the substrate 110 in the vertical direction (Z direction). The level of a particular component may be measured from a lower surface of that component (e.g. the level of the layer/element upon which it is located).

An inter-wiring insulating film IMD may be on the plurality of lower wiring patterns BP1 and the insulating pattern 168. The inter-wiring insulating film IMD may have a double structure including a first insulating film 171 and a second insulating film 172, without being limited thereto. Each of the first insulating film 171 and the second insulating film 172 may include a silicon nitride film, a silicon oxide film, or a combination thereof. In some example embodiments, the first insulating film 171 and the second insulating film 172 may include different material films, each of which is selected out of a silicon nitride film and a silicon oxide film. In other example embodiments, the first insulating film 171 and the second insulating film 172 may include the same material film, which is selected out of a silicon nitride film and a silicon oxide film. For example, the first insulating film 171 may include a silicon nitride film, and the second insulating film 172 may include a silicon oxide film.

In the peripheral circuit area CORE/PERI, a plurality of middle wiring patterns BP2 may be on the inter-wiring insulating film IMD. The plurality of middle wiring patterns BP2 may be at a first vertical level LV1, which is farther from the substrate 110 in the vertical direction (Z direction) than the reference vertical level, which is the vertical level LV0 at which the plurality of conductive landing pads LP and the plurality of lower wiring patterns BP1 are located. The first vertical level LV1 located in the plurality of middle wiring patterns BP2 may be a vertical level closer to the substrate 110 than a vertical level LVT of an uppermost surface of the capacitor structure CPS located in the cell array area MCA (e.g., an uppermost surface of the upper electrode UE included in the capacitor structure CPS). The plurality of middle wiring patterns BP2 may be apart from each other on the inter-wiring insulating film IMD in a lateral direction (e.g., X direction or Y direction).

A selected one of the plurality of middle wiring patterns BP2 may be connected to a selected one of the plurality of lower wiring patterns BP1 through a lower contact plug CP1. The lower contact plug CP1 may pass through the inter-wiring insulating film IMD in the vertical direction (Z direction) and contact each of the lower wiring pattern BP1 corresponding thereto and the middle wiring pattern BP2 corresponding thereto. The lower contact plug CP1 may be integrally connected to the middle wiring pattern BP2 corresponding thereto. Each of the lower contact plug CP1 and the middle wiring pattern BP2 may include a conductive barrier film 174 and a metal film 175 of which at least a portion is covered by the conductive barrier film 174. In some example embodiments, the conductive barrier film 174 may include a metal, a conductive metal nitride, or a combination thereof. For example, the conductive barrier film 174 may include Ti/TiN, and the metal film 175 may include tungsten (W), without being limited thereto.

As shown in the enlarged view of FIG. 5, a top surface of the inter-wiring insulating film IMD may include a plurality of recessed top surfaces RT1, which are recessed further toward the substrate 110 than other portions of the top surface thereof. The plurality of recessed top surfaces RT1 may include a surface of the second insulating film 172, which is an uppermost layer of the inter-wiring insulating film IMD. Each of the plurality of recessed top surfaces RT1 may be between two adjacent ones of the plurality of middle wiring patterns BP2. For example, the plurality of recessed top surfaces RT1 may include a pair of recessed top surfaces RT1, which are respectively on both (e.g. opposite) sides in a lateral direction (e.g., X direction or Y direction) of a selected one of the plurality of middle wiring patterns BP2.

In the peripheral circuit area CORE/PERI, a surface of each of the plurality of middle wiring patterns BP2 may be covered by a peripheral protective insulating liner STS. At least a portion of the peripheral protective insulating liner STS may have a greater thickness than the cell protective insulating liner STC located in the cell array area MCA. As used herein, a thickness of each of the cell protective insulating liner STC and the peripheral protective insulating liner STS may refer to a size of each of the cell protective insulating liner STC and the peripheral protective insulating liner STS from a target surface covered by the cell protective insulating liner STC and the peripheral protective insulating liner STS in a direction perpendicular to the target surface. For example, a size of the peripheral protective insulating liner STS covering a top surface of each of the plurality of middle wiring patterns BP2 in the vertical direction (Z direction) in the peripheral circuit area CORE/PERI may be greater than a size of the cell protective insulating liner STC covering the top surface of each of the plurality of conductive landing pads LP and the isolated insulating pattern 170 in the vertical direction (Z direction) in the cell array area MCA.

The peripheral protective insulating liner STS may have a multilayered structure including a plurality of insulating liners. The peripheral protective insulating liner STS may include a first insulating liner ST1 covering the top surface and sidewalls of the middle wiring pattern BP2 and a second insulating liner ST2 that is apart from the middle wiring pattern BP2 with the first insulating liner ST1 therebetween. The second insulating liner ST2 may be apart from the middle wiring pattern BP2 with the first insulating liner ST1 therebetween and cover the top surface and the sidewalls of the middle wiring pattern BP2. In some example embodiments, each of the first insulating liner ST1 and the second insulating liner ST2 may include a silicon boron nitride (SiBN) film, a silicon nitride (SiN) film, a silicon carbonitride (SiCN) film, or a combination thereof. In some example embodiments, the first insulating liner ST1 and the second insulating liner ST2 may include the same material as each other. In some other example embodiments, the first insulating liner ST1 and the second insulating liner ST2 may include different materials from each other. In some example embodiments, the second insulating liner ST2 located in the peripheral protective insulating liner STS may include the same material as the cell protective insulating liner STC located in the cell array area MCA and have the same thickness as the cell protective insulating liner STC.

The peripheral protective insulating liner STS may continuously extend from above the surface of the middle wiring pattern BP2 to above the plurality of recessed top surfaces RT1 of the inter-wiring insulating film IMD to contact the plurality of recessed top surfaces RT1 of the top surface of the inter-wiring insulating film IMD. The peripheral protective insulating liner STS may include a plurality of curved portions CX1, which conformally contact the plurality of recessed top surfaces RT1 of the inter-wiring insulating film IMD and convexly extend toward the substrate 110. The plurality of curved portions CX1 included in the peripheral protective insulating liner STS may contact the second insulating film 172 of the inter-wiring insulating film IMD but not contact the first insulating film 171 thereof.

The capacitor structure CPS located in the cell array area MCA and the peripheral protective insulating liner STS arranged in the peripheral circuit area CORE/PERI may be covered by an upper interlayer insulating film 190. In the peripheral circuit area CORE/PERI, an upper wiring pattern MP may be on the upper interlayer insulating film 190. The upper wiring pattern MP may be at a second vertical level LV2 that is farther from the substrate 110 than the vertical level LVT of an uppermost surface of the upper electrode UE of the capacitor structure CPS located in the cell array area MCA.

A selected one of the plurality of middle wiring patterns BP2 may be connected to the upper wiring pattern MP through an upper contact plug CP2. The upper contact plug CP2 may pass through the upper interlayer insulating film 190 and the peripheral protective insulating liner STS in the vertical direction (Z direction) and contact each of the upper wiring pattern MP corresponding thereto and the middle wiring pattern BP2 corresponding thereto. The upper contact plug CP2 may be integrally connected to the upper wiring pattern MP corresponding thereto. Each of the upper contact plug CP2 and the upper wiring pattern MP may include a conductive barrier film 194 and a metal film 195 of which at least a portion is covered by the conductive barrier film 194. In some example embodiments, the conductive barrier film 194 may include a metal, a conductive metal nitride, or a combination thereof. For example, the conductive barrier film 194 may include Ti/TiN, and the metal film 195 may include tungsten (W), without being limited thereto.

Even when a pattern density and a required number of wirings increase in each of the cell array area MCA and the peripheral circuit area CORE/PERI including the core area 30 adjacent to the cell array area MCA, in order to ensure the required number of wirings without increasing a planar area of a wiring structure, the IC device 100 described with reference to FIGS. 1 to 5 may include the plurality of middle wiring patterns BP2, which extend in the lateral direction (X direction or Y direction) at the first vertical level LV1. The first vertical level LV1 may be farther from the substrate 10 in the vertical direction (Z direction) than the reference vertical direction that is the vertical level LV0 at which the plurality of lower wiring patterns BP1 are arranged in the peripheral circuit area CORE/PERI, and is closer to the substrate 110 in the vertical direction (Z direction) than the vertical level LVT of the uppermost surface of the capacitor structure CPS arranged in the cell array area MCA. By using a region, which is not used as a wiring space in conventional technology, as a wiring region as described above, the number of wiring layers stacked in the vertical direction (Z direction) may increase without increasing a planar area of the wiring structure. Thus, a sufficient number of wirings required to implement the IC device 100 may be ensured. In addition, at least a portion of the peripheral protective insulating liner STS covering the surface of each of the plurality of middle wiring patterns BP2 may have a greater thickness than a protective insulating liner covering other wiring patterns or other conductive patterns (e.g., the cell protective insulating liner STC arranged in the cell array area MCA). Therefore, a process margin may improve in processes of forming a wiring structure including the plurality of middle wiring patterns BP2, and electrical reliability of unit devices located in the peripheral circuit area CORE/PERI may be ensured.

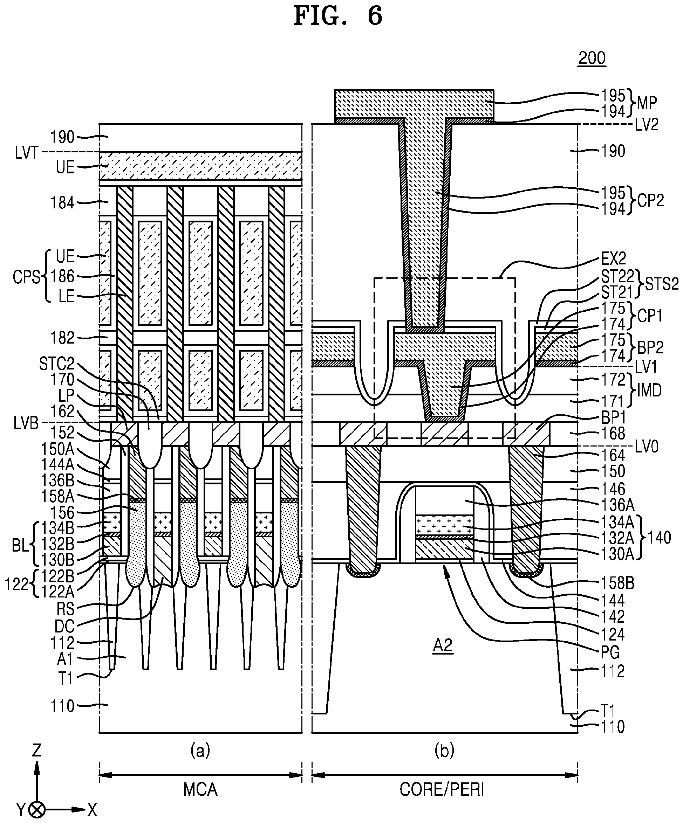

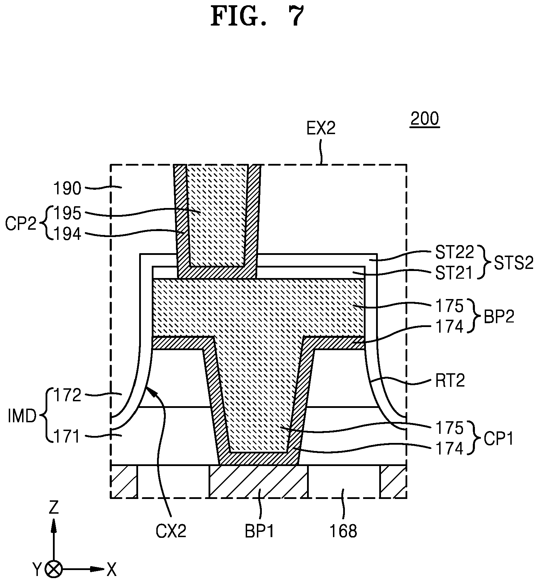

FIG. 6 is a cross-sectional view of an IC device 200 according to some example embodiments. In FIG. 6, (a) shows a cross-sectional view of components in a cell array area MCA of the IC device 200, and (b) shows a cross-sectional view of components in a peripheral circuit area CORE/PERI of the IC device 200. In FIG. 6, (a) illustrates a cross-sectional configuration of a portion corresponding to a cross-section taken along line A - A' of FIG. 3 in the IC device 200. FIG. 7 is an enlarged cross-sectional view of portion "EX2" of FIG. 6. In FIGS. 6 and 7, the same reference numerals are used to denote the same elements as in FIGS. 1 to 5, and thus, repeated descriptions thereof are omitted.

Referring to FIGS. 6 and 7, the IC device 200 may substantially have the same configuration as the IC device 100 described with reference to FIGS. 4 and 5. However, in a peripheral circuit area CORE/PERI of the IC device 200, a surface of each of a plurality of middle wiring patterns BP2 may be covered by a peripheral protective insulating liner STS2. At least a portion of the peripheral protective insulating liner STS2 may have a greater thickness than a cell protective insulating liner STC located in the cell array area MCA. For example, a thickness of the peripheral protective insulating liner STS2 covering a top surface of each of the plurality of middle wiring patterns BP2 in a vertical direction (Z direction) in the peripheral circuit area CORE/PERI may be greater than a thickness of a top surface of each of a plurality of conductive landing pads LP and the isolated insulating pattern 170 in the vertical direction (Z direction) in the cell array area MCA.

The peripheral protective insulating liner STS2 may have a multilayered structure including a plurality of insulating liners. The peripheral protective insulating liner STS2 may include a first insulating liner ST21 in contact with the top surface of the middle wiring pattern BP2 and a second insulating liner ST22 covering the top surface and sidewalls of the middle wiring pattern BP2. The first insulating liner ST21 may not contact the sidewalls of the middle wiring pattern BP2. The second insulating liner ST22 may be apart from the top surface of the middle wiring pattern BP2 with the first insulating liner ST21 therebetween and be in contact with the sidewalls of the middle wiring pattern BP2. In embodiments, each of the first insulating liner ST21 and the second insulating liner ST22 may include a silicon boron nitride (SiBN) film, a silicon nitride (SiN) film, a silicon carbonitride (SiCN) film, or a combination thereof. In some example embodiments, the first insulating liner ST21 and the second insulating liner ST22 may include the same material as each other. In some other example embodiments, the first insulating liner ST21 and the second insulating liner ST22 may include different materials from each other. In some example embodiments, the second insulating liner ST22 of the peripheral protective insulating liner STS2 may include the same material as the cell protective insulating liner STC located in the cell array area MCA and have the same thickness as the cell protective insulating liner STC.

As shown in the enlarged view of FIG. 7, a top surface of the inter-wiring insulating film IMD may include a plurality of recessed top surfaces RT2, which are recessed further toward a substrate 110 than other portions of the top surface thereof. The plurality of recessed top surfaces RT2 may include a surface of the second insulating film 172, which is an uppermost layer of the inter-wiring insulating film IMD, and a surface of the first insulating film 171, which is under the second insulating film 172. Each of the plurality of recessed top surfaces RT2 may be between two adjacent ones of the plurality of middle wiring patterns BP2. For example, the plurality of recessed top surfaces RT2 may include a pair of recessed top surfaces RT2, which are respectively on both (e.g. opposite) sides in a lateral direction (e.g., X direction or Y direction) of a selected one of the plurality of middle wiring patterns BP2.

The peripheral protective insulating liner STS2 may continuously extend from above the surface of the middle wring pattern BP2 to above the plurality of recessed top surfaces RT2 of the inter-wiring insulating film IMD to contact the plurality of recessed top surfaces RT2 included in the top surface of the inter-wiring insulating film IMD. The peripheral protective insulating liner STS2 may include a plurality of curved portions CX2, which conformally contacts the plurality of recessed top surfaces RT2 of the inter-wiring insulating film IMD and convexly extends toward the substrate 110. The plurality of curved portions CX2 included in the peripheral protective insulating liner STS2 may be in contact with each of the first insulating film 171 and the second insulating film 172 of the inter-wiring insulating film IMD.

A capacitor structure CPS located in the cell array area MCA and the peripheral protective insulating liner STS2 located in the peripheral circuit area CORE/PERI may be covered by an upper interlayer insulating film 190. In the peripheral circuit area CORE/PERI, an upper wiring pattern MP may be on the upper interlayer insulating film 190. A selected one of the plurality of middle wiring patterns BP2 may be connected to the upper wiring pattern MP through the upper contact plug CP2. The upper contact plug CP2 may pass through the upper interlayer insulating film 190 and the peripheral protective insulating liner STS2 in the vertical direction (Z direction) and contact each of the upper wiring pattern MP corresponding thereto and the middle wiring pattern BP2 corresponding thereto.

Similar to the IC device 100 described with reference to FIGS. 1 to 5, the IC device 200 described with reference to FIGS. 6 and 7 may use a region, which is not used as a wiring space in conventional technology, as a wiring region, and thus, the number of wiring layers stacked in the vertical direction (Z direction) may increase without increasing a planar area of a wiring structure. Thus, a sufficient number of wirings required to implement the IC device 200 may be ensured. In addition, at least a portion of the peripheral protective insulating liner STS2 covering the surface of each of the plurality of middle wiring patterns BP2 may have a greater thickness than a protective insulating liner covering other wiring patterns or other conductive patterns (e.g., the cell protective insulating liner STC arranged in the cell array area MCA). Therefore, a process margin may improve in processes of forming a wiring structure including the plurality of middle wiring patterns BP2, and electrical reliability of unit devices located in the peripheral circuit area CORE/PERI may be ensured.

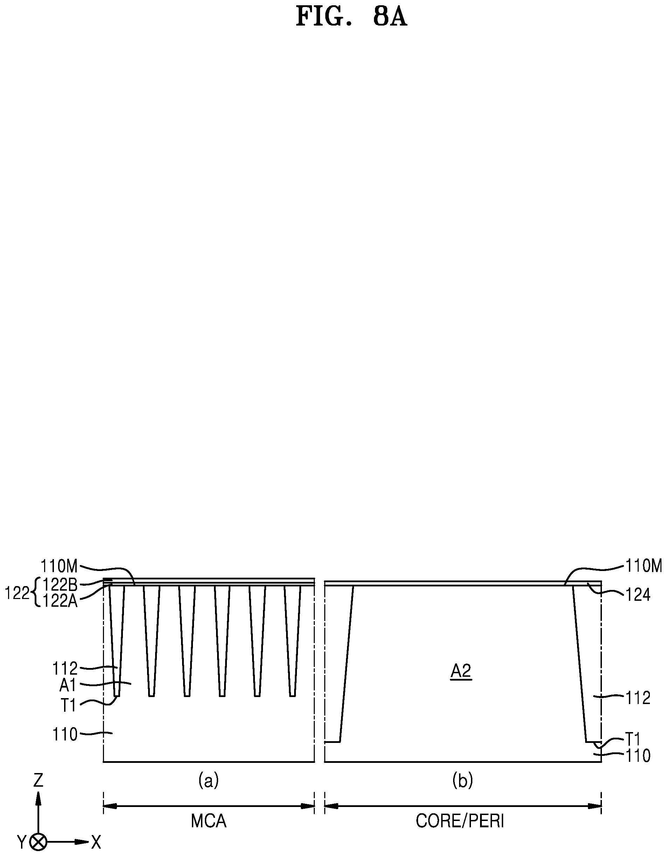

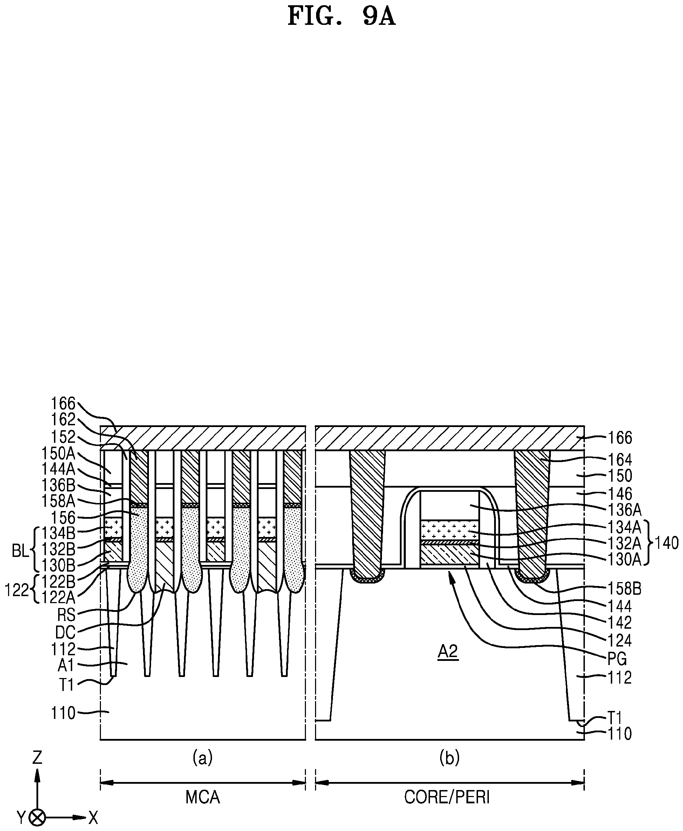

FIGS. 8A to 8L and 9A to 9O are cross-sectional views of a process sequence of a method of manufacturing an IC device, according to some example embodiments. The method of manufacturing the IC device 100, which has been described with reference to FIGS. 4 and 5, is described with reference to FIGS. 8A to 8L and 9A to 9O. In FIGS. 8A to 8L and 9A to 9O, the same reference numerals are used to denote the same elements as in FIGS. 1 to 5, and thus, repeated descriptions thereof are omitted.

Referring to FIG. 8A, a plurality of device isolation trenches T1 and a plurality of device isolation films 112 may be formed at a substrate 110 having a cell array area MCA and a peripheral circuit area CORE/PERI. Thus, a plurality of cell active areas A1 may be defined in the cell array area MCA of the substrate 110, and a peripheral active area A2 may be defined in the peripheral circuit area CORE/PERI.

A plurality of word line trenches, which extend parallel to each other, may be formed in the cell array area MCA on the substrate 110. Thereafter, a plurality of gate dielectric films, a plurality of word lines, and a plurality of buried insulating films may be formed, for example sequentially formed, inside the plurality of word line trenches. The plurality of word lines may constitute the plurality of word lines WL shown in FIG. 3. Impurity ions may be implanted into portions of the plurality of cell active areas A1 on both sides of the plurality of word lines WL, and thus, a plurality of source/drain regions may be formed in upper portions of the plurality of cell active areas A1. In embodiments, the plurality of source/drain regions may be formed before the plurality of word lines WL are formed.

Thereafter, a buffer film 122 may be formed on a main surface 110M of the substrate 110 in the cell array area MCA, and a gate dielectric film 124 may be formed on the main surface 110M of the substrate 110 in the peripheral circuit area CORE/PERI. The buffer film 122 may include a first insulating film 122A and a second insulating film 122B. Each of the first insulating film 122A and the second insulating film 122B may include an oxide film, a nitride film, or a combination thereof.

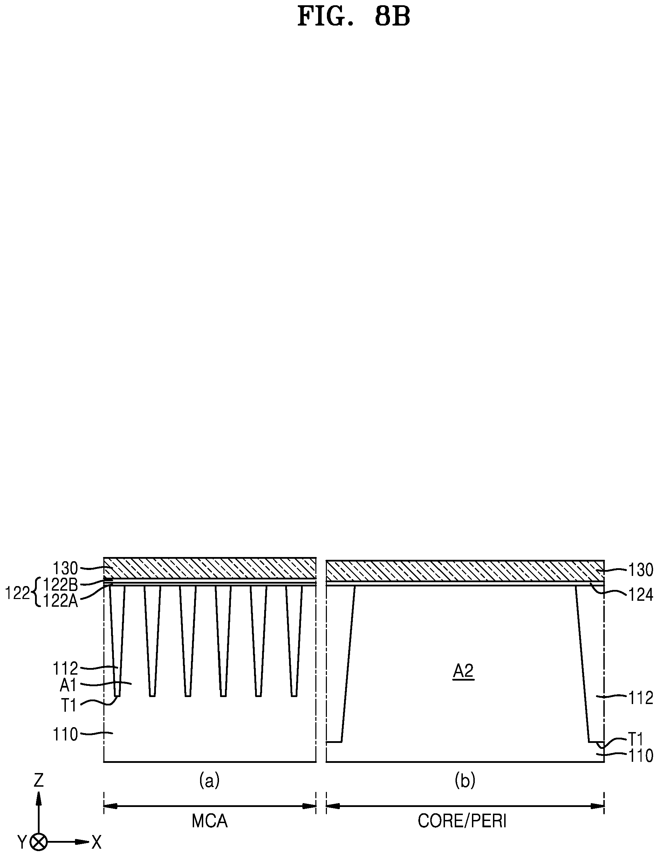

Referring to FIG. 8B, a lower conductive layer 130 may be formed on the buffer film 122 of the cell array area MCA and the gate dielectric film 124 of the peripheral circuit area CORE/PERI. The lower conductive layer 130 may include doped polysilicon.

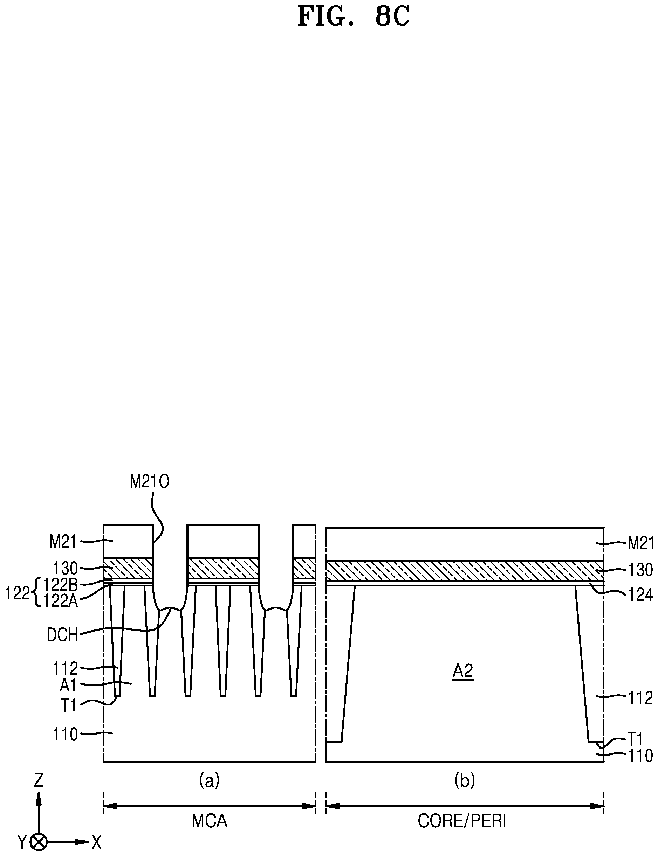

Referring to FIG. 8C, a mask pattern M21 may be formed on the lower conductive layer 130 in the cell array area MCA and the peripheral circuit area CORE/PERI. Thereafter, the lower conductive layer 130 exposed through an opening M21O of the mask pattern M21 may be etched in the cell array area MCA. A portion of the substrate 110 and a portion of the device isolation film 112, which are exposed as the result of the etching of the lower conductive layer 130, may be etched to form a direct contact hole DCH exposing the cell active area A1 of the substrate 110. The mask pattern M21 may include an oxide film, a nitride film, or a combination thereof.

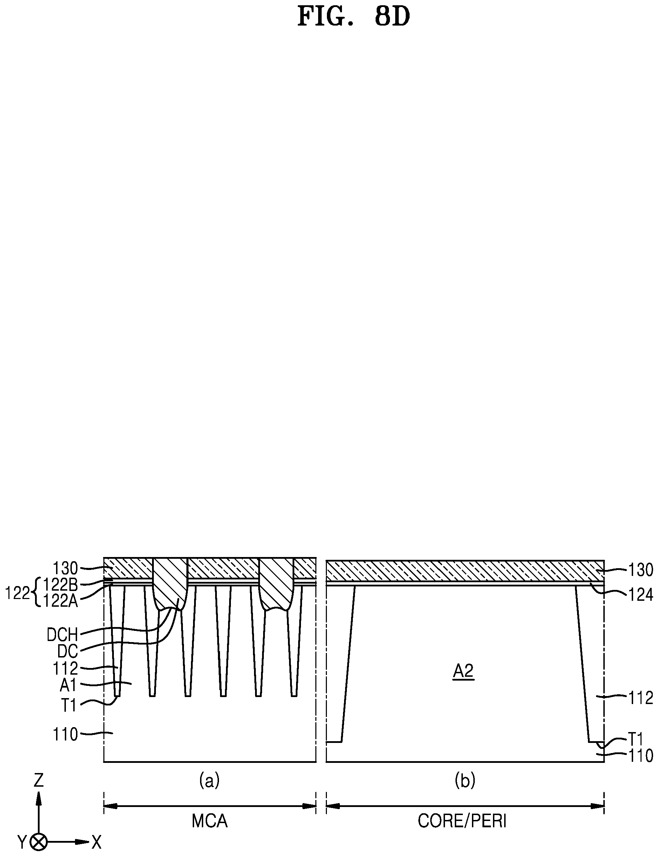

Referring to FIG. 8D, the mask pattern M21 may be removed from the resultant structure of FIG. 8C, and a direct contact DC may be formed inside the direct contact hole DCH in the cell array area MCA. An example process of forming the direct contact DC may include forming a conductive layer inside the direct contact hole DCH and on the lower conductive layer 130 to such a sufficient thickness as to fill the direct contact hole DCH and etching back the conductive layer such that the conductive layer remains only inside the direct contact hole DCH. The conductive layer may include doped polysilicon, Ge, W, WN, Co, Ni, Al, Mo, Ru, Ti, TiN, Ta, TaN, Cu, or a combination thereof.

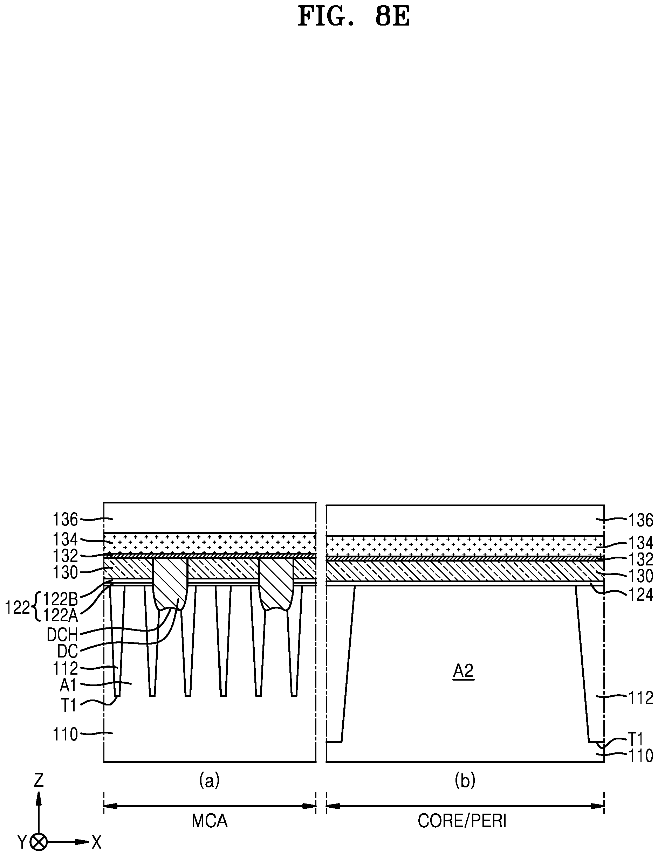

Referring to FIG. 8E, a middle conductive layer 132, an upper conductive layer 134, and a lower insulating capping layer 136 may be formed, for example sequentially formed, on the lower conductive layer 130 and the direct contact DC in the cell array area MCA and the peripheral circuit area CORE/PERI.

Each of the middle conductive layer 132 and the upper conductive layer 134 may include TiN, TiSiN, W, tungsten silicide, or a combination thereof. The lower insulating capping layer 136 may include a silicon nitride film. In some example embodiments, the middle conductive layer 132 may include TiN, TiSiN, or a combination thereof, and the upper conductive layer 134 may include W. The lower insulating capping layer 136 may include a silicon nitride film.

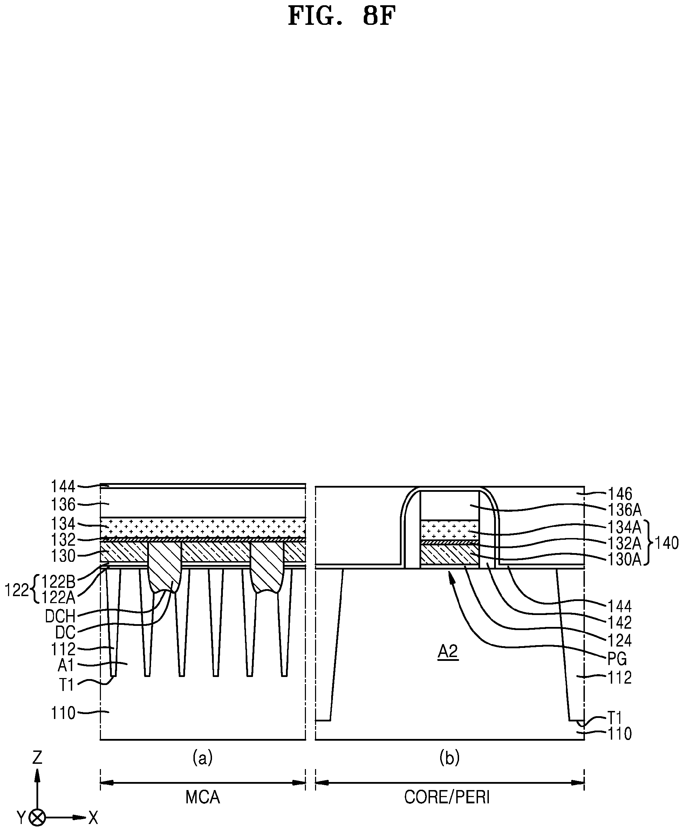

Referring to FIG. 8F, in the resultant structure of FIG. 8E, while the cell array area MCA is being covered by a mask pattern, the gate dielectric film 124, the lower conductive layer 130, the middle conductive layer 132, the upper conductive layer 134, and the lower insulating capping layer 136 may be patterned in the peripheral circuit area CORE/PERI. Thus, a gate electrode 140 including a lower conductive pattern 130A, a middle conductive pattern 132A, and an upper conductive pattern 134A and a gate capping pattern 136A covering the gate electrode 140 may be formed on the gate dielectric film 124. Afterwards, insulating spacers 142 may be formed on both sidewalls of a gate structure PG, which includes a stack structure of the gate dielectric film 124, the gate electrode 140, and the gate capping pattern 136A, and an ion implantation process may be performed to form source/drain regions on both sides of the gate structure PG in the peripheral active area A2. In some example embodiments, the insulating spacer 142 may include an oxide film, a nitride film, or a combination thereof.

Thereafter, the mask pattern covering the cell array area MCA may be removed to expose the insulating capping layer 136 in the cell array area MCA, and an insulating thin film 144 may be formed to cover the entire surface of the resultant structure in which the cell array area MCA and the peripheral circuit area CORE/PERI are exposed. Thereafter, in the peripheral circuit area CORE/PERI, a lower interlayer insulating film 146 may be formed to fill a space around the gate structure PG. The insulating thin film 144 may include a silicon nitride film. The lower interlayer insulating film 146 may include polysilazane, without being limited thereto.

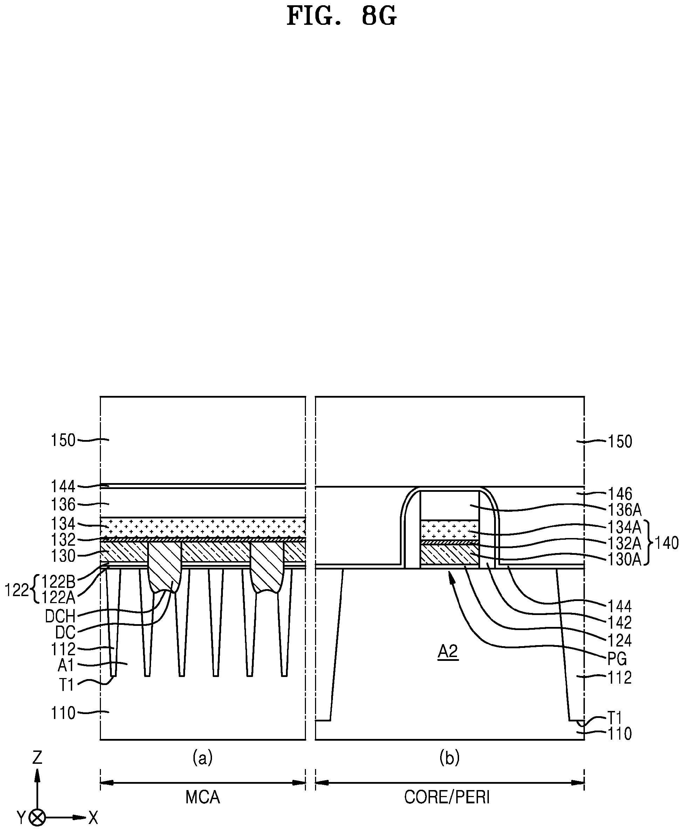

Referring to FIG. 8G, in the cell array area MCA and the peripheral circuit area CORE/PERI, an upper insulating capping layer 150 may be formed on the insulating thin film 144 and the lower interlayer insulating film 146. The upper insulating capping layer 150 may include a silicon nitride film.

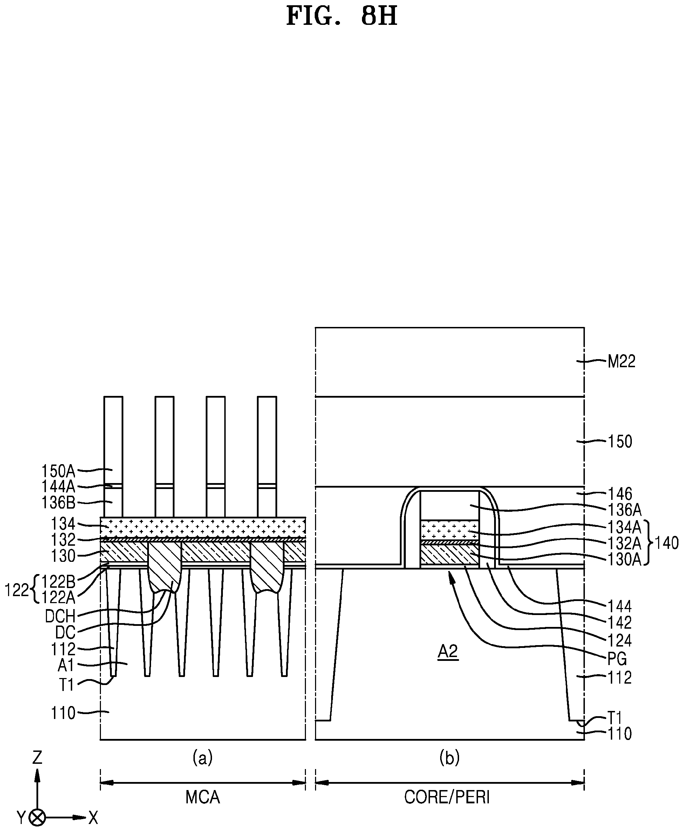

Referring to FIG. 8H, while the upper insulating capping layer 150 is being covered by a mask pattern M22 in the peripheral circuit area CORE/PERI, the upper insulating capping layer 150, the insulating thin film 144, and the lower insulating capping layer 136 may be patterned by using a photolithography process in the cell array area MCA. Thus, a lower insulating capping pattern 136B, an insulating thin film pattern 144A, and an upper insulating capping pattern 150A, which are stacked, for example sequentially stacked, on the upper conductive layer 134, may be formed.

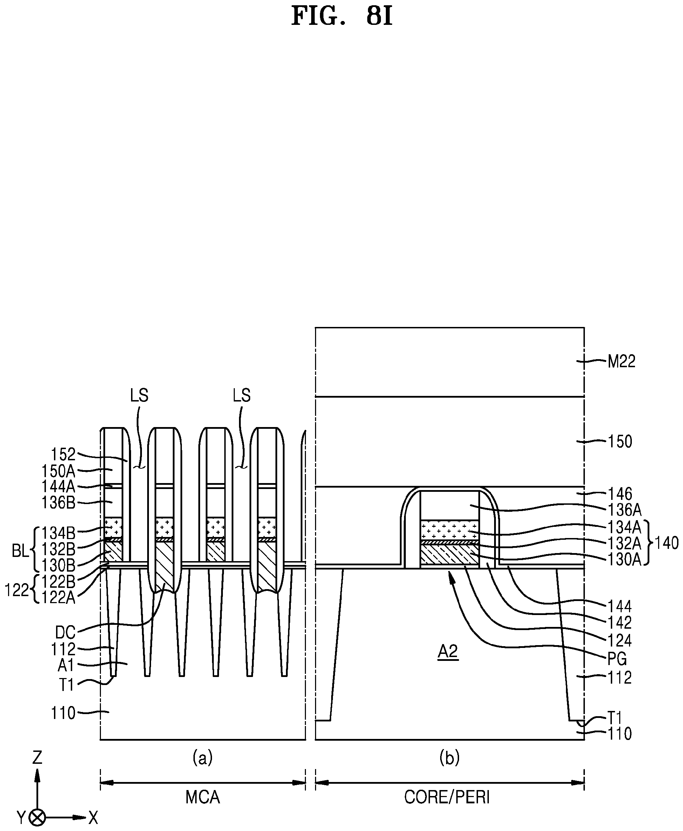

Referring to FIG. 8I, while the upper insulating capping layer 150 is being covered by the mask pattern M22 in the peripheral circuit area CORE/PERI, the upper conductive layer 134, the middle conductive layer 132, and the lower conductive layer 130 may be etched by using the lower insulating capping pattern 136B, the insulating thin film pattern 144A, and the upper insulating capping pattern 150A as etch masks in the cell array area MCA. Thus, a plurality of bit lines BL, each of which includes a lower conductive pattern 130B, a middle conductive pattern 132B, and an upper conductive pattern 134B, may be formed.

Thereafter, a plurality of insulating spacers 152 may be formed to cover both sidewalls of an insulating capping structure including the lower insulating capping pattern 136B, the insulating thin film pattern 144A, and the upper insulating capping pattern 150A and both sidewalls of the bit line BL. The plurality of insulating spacers 152 may be formed to fill the direct contact hole DCH around the direct contact DC. After the plurality of insulating spacers 152 are formed, a line space LS may remain between two adjacent ones of the plurality of bit lines BL. A height of the upper insulating capping pattern 150A may be reduced due to etching processes involved during the formation of the plurality of bit lines BL and the plurality of insulating spacers 152.

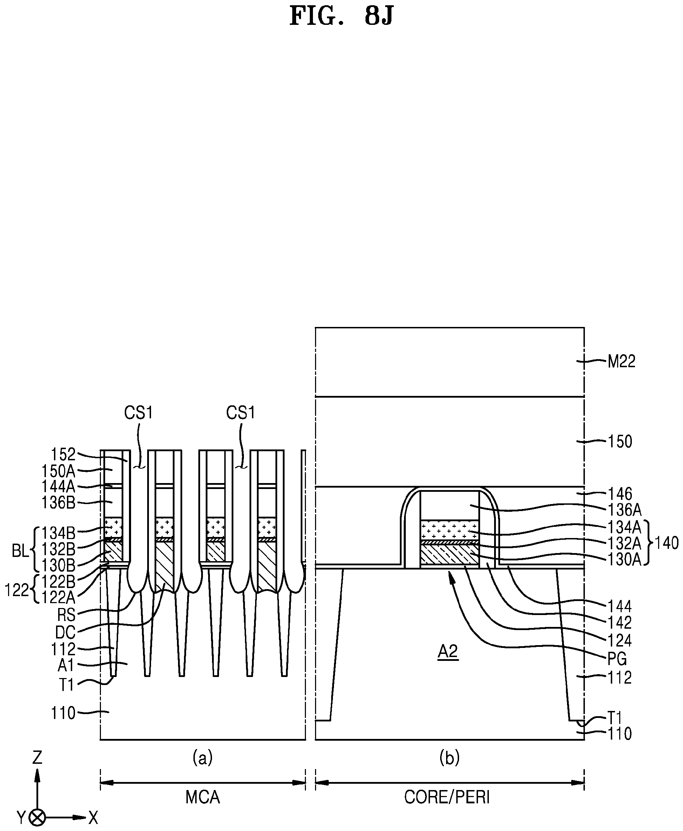

Referring to FIG. 8J, while the upper insulating capping layer 150 is being covered by the mask pattern M22 in the peripheral circuit area CORE/PERI, a plurality of insulating fences may be respectively formed between the plurality of bit lines BL in the cell array area MCA. As a result, one line space LS may be separated into a plurality of contact spaces CS1, each of which has a column shape. A width of each of the plurality of contact spaces CS1 in a lateral direction may be defined by the plurality of insulating spacers 152 and the plurality of insulating fences. Because the upper insulating capping pattern 150A and the insulating spacers 152 are exposed to an etching atmosphere involved during the formation of the plurality of insulating fences, the upper insulating capping pattern 150A and the insulating spacers 152 may be consumed and further reduced in height.

Afterwards, portions of structures exposed through the plurality of contact spaces CS1 may be removed, and thus, a plurality of recess spaces RS exposing the cell active area A1 of the substrate 110 may be respectively formed between the plurality of bit lines BL.

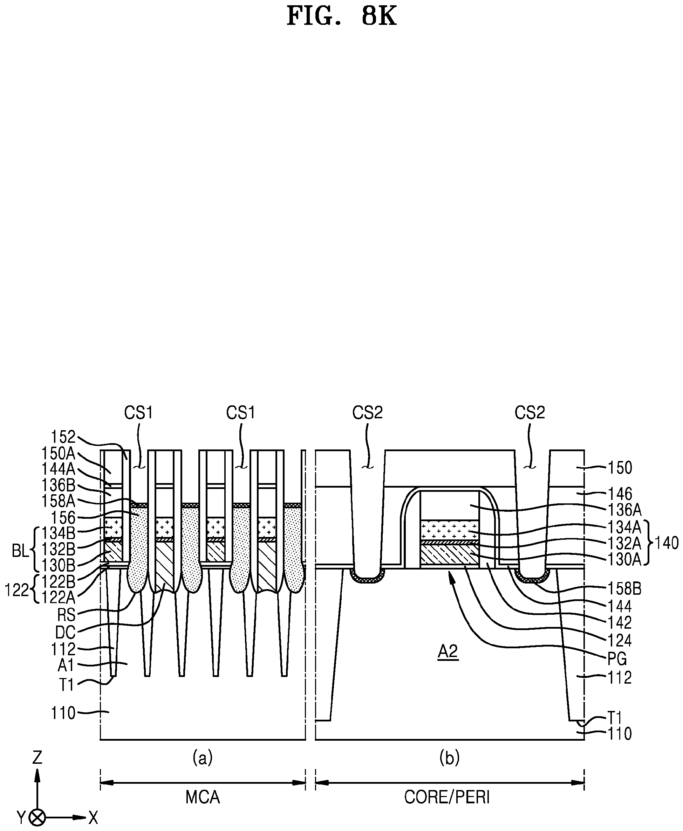

Referring to FIG. 8K, as in the resultant structure of FIG. 8J, while the upper insulating capping layer 150 is being covered by the mask pattern M22 in the peripheral circuit area CORE/PERI, a plurality of lower cell contact plugs 156, which fill the plurality of recess spaces RS and partially fill the contact spaces CS1 between the plurality of bit lines BL, may be respectively formed between the plurality of bit lines BL in the cell array area MCA. The plurality of lower cell contact plugs 156 may include doped polysilicon.

Next, the mask pattern M22 may be removed from the peripheral circuit area CORE/PERI to expose the upper insulating capping layer 150. Thereafter, while the cell array area MCA is being covered by the mask pattern, the upper insulating capping layer 150, the lower interlayer insulating film 146, and the insulating thin film 144 may be etched in the peripheral circuit area CORE/PERI, and thus, a plurality of contact spaces CS2 exposing the peripheral active area A2 of the substrate 110 may be formed.

The mask pattern covering the cell array area MCA may be removed. Thereafter, a metal silicide film 158A may be formed on a lower cell contact plug 156 exposed through the plurality of contact spaces CS1 in the cell array area MCA, and a metal silicide film 158B may be formed on a surface of the peripheral active area A2, which is exposed through the plurality of contact spaces CS2, in the peripheral circuit area CORE/PERI. The metal silicide films 158A and 158B may be formed simultaneously or by using separate processes. Each of the metal silicide films 158A and 158B may include cobalt silicide, nickel silicide, or manganese silicide, without being limited thereto.

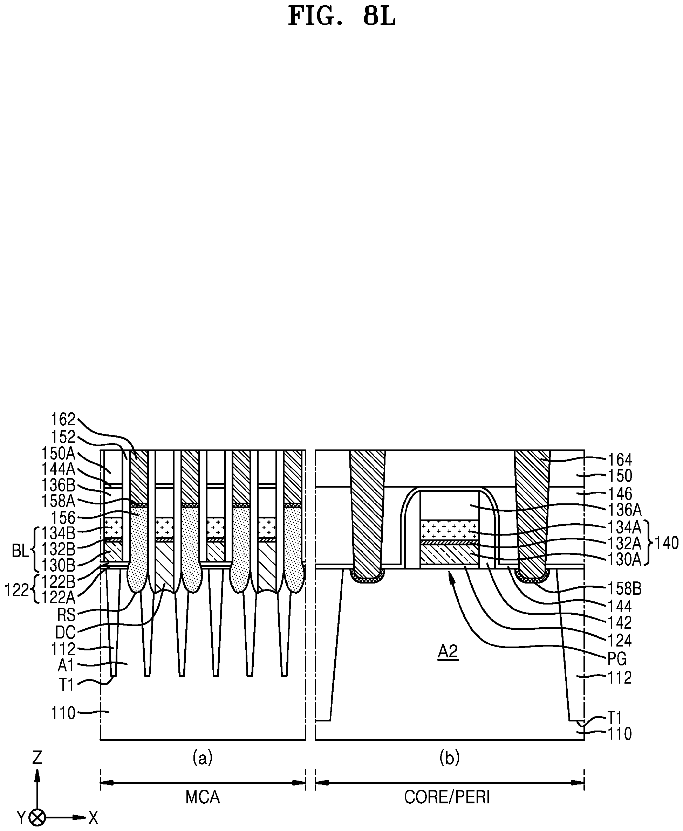

Referring to FIG. 8L, in the resultant structure of FIG. 8K, a plurality of upper cell contact plugs 162 filling the plurality of contact spaces CS 1 remaining on the metal silicide film 158A may be formed in the cell array area MCA, and a plurality of peripheral contact plugs 164 filling the plurality of contact spaces CS2 may be formed in the peripheral circuit area CORE/PERI. In some example embodiments, the process of forming the plurality of upper cell contact plugs 162 and the process of forming the plurality of peripheral contact plugs 164 may be performed at the same time. In the peripheral circuit area CORE/PERI, each of the plurality of peripheral contact plugs 164 may be electrically connected to the source/drain region formed in the peripheral active area A2 of the substrate 110.

In the cell array area MCA, respective top surfaces of the plurality of upper cell contact plugs 162, a plurality of upper insulating capping patterns 150A, and the plurality of insulating spacers 152 may be planarized to extend on the same plane. In the peripheral circuit area CORE/PERI, respective top surfaces of the plurality of peripheral contact plugs 164 and the upper insulating capping layer 150 may be planarized to extend on the same plane.

Referring to FIG. 9A, in the resultant structure of FIG. 8L, a first conductive layer 166 may be formed in the cell array area MCA and the peripheral circuit area CORE/PERI. The first conductive layer 166 may be formed to cover the plurality of upper cell contact plugs 162 in the cell array area MCA and cover the plurality of peripheral contact plugs 164 in the peripheral circuit area CORE/PERI.

The first conductive layer 166 may include a metal, a conductive metal nitride, or a combination thereof. In some example embodiments, the first conductive layer 166 may include TiN, W, or a combination thereof. In an example, the first conductive layer 166 may include only a TiN film. In another example embodiment, the first conductive layer 166 may include a stack structure of a TiN barrier film and a W film.

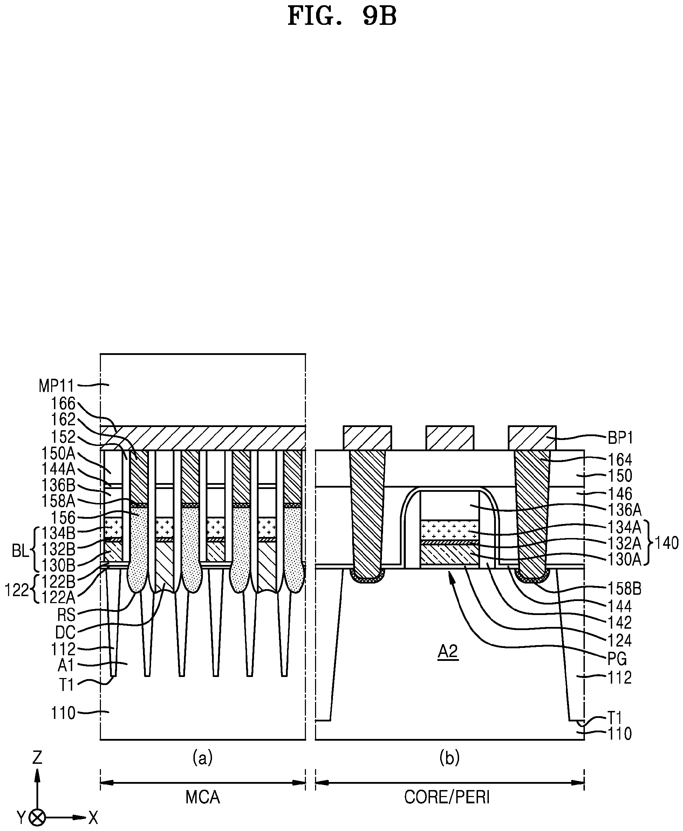

Referring to FIG. 9B, a mask pattern MP11 covering the first conductive layer 166 may be formed in the cell array area MCA, and the first conductive layer 166 may be patterned to form a plurality of lower wiring patterns BP1 in the peripheral circuit area CORE/PERI.

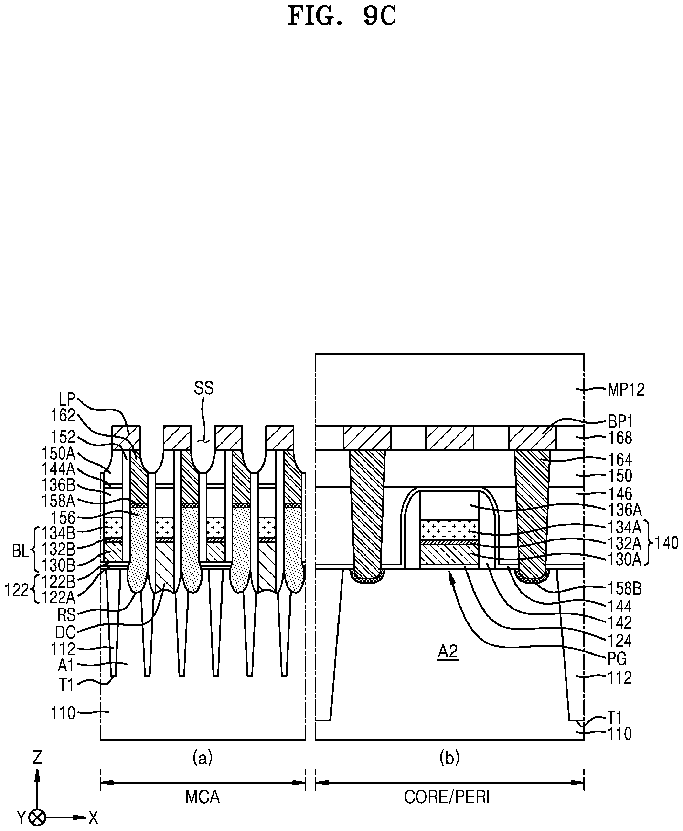

Referring to FIG. 9C, in the resultant structure of FIG. 9B, an insulating pattern 168 may be formed to fill a space between two adjacent ones of the plurality of lower wiring patterns BP1, the mask pattern MP11 may be removed from the cell array area MCA, and a mask pattern MP12 covering the plurality of lower wiring patterns BP1 and the insulating pattern 168 may be formed in the peripheral circuit area CORE/PERI. The mask pattern MP12 may include a photoresist pattern. After the mask pattern MP12 is formed in the peripheral circuit area CORE/PERI, the first conductive layer 166 exposed in the cell array area MCA may be patterned to form a plurality of conductive landing pads LP, and a portion of a lower structure may be etched through a space between two adjacent ones of the plurality of conductive landing pads LP to form a separation space SS.

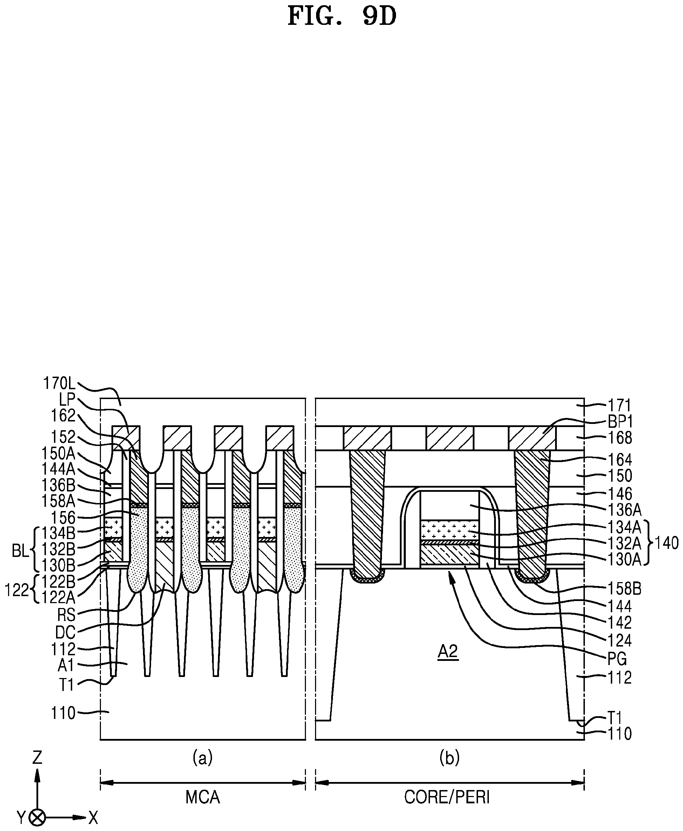

Referring to FIG. 9D, the mask pattern MP12 may be removed from the resultant structure of FIG. 9C. An isolated insulating film 170L filling the separation space SS and covering a top surface of each of the plurality of conductive landing pads LP may be formed in the cell array area MCA, and a first insulating film 171 covering the plurality of lower wiring patterns BP1 and the insulating pattern 168 may be formed in the peripheral circuit area CORE/PERI. The isolated insulating film 170L and the first insulating film 171 may include the same material. The isolated insulating film 170L and the first insulating film 171 may be formed at the same time.

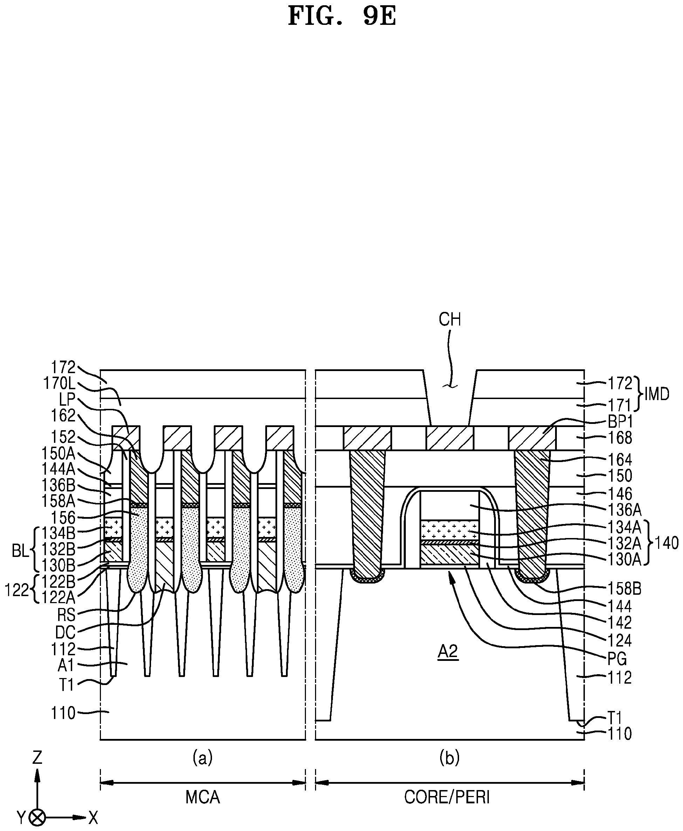

Referring to FIG. 9E, in the cell array area MCA and the peripheral circuit area CORE/PERI of the resultant structure of FIG. 9D, a second insulating film 172 may be formed on the isolated insulating film 170L and the first insulating film 171. Thereafter, in the peripheral circuit area CORE/PERI, the first insulating film 171 and the second insulating film 172 may be partially etched to form a contact hole CH exposing a top surface of the lower wiring pattern BP1. In the peripheral circuit area CORE/PERI, the first insulating film 171 and the second insulating film 172 may constitute an inter-wiring insulating film IMD.

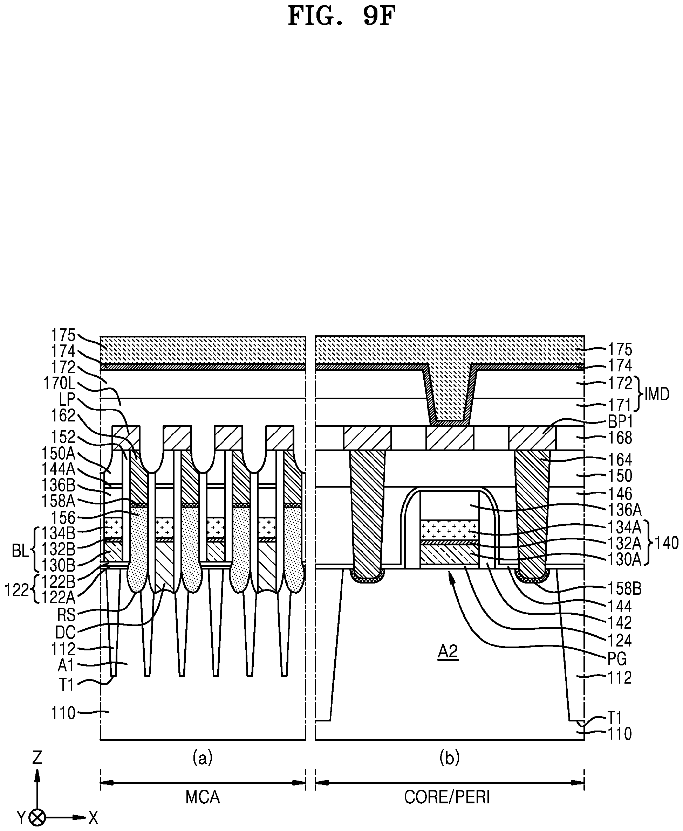

Referring to FIG. 9F, in the peripheral circuit area CORE/PERI of the resultant structure of FIG. 9E, a conductive barrier film 174 and a metal film 175 may be formed, for example sequentially formed, to fill the contact hole CH and cover the second insulating film 172 in the cell array area MCA and the peripheral circuit area CORE/PERI.

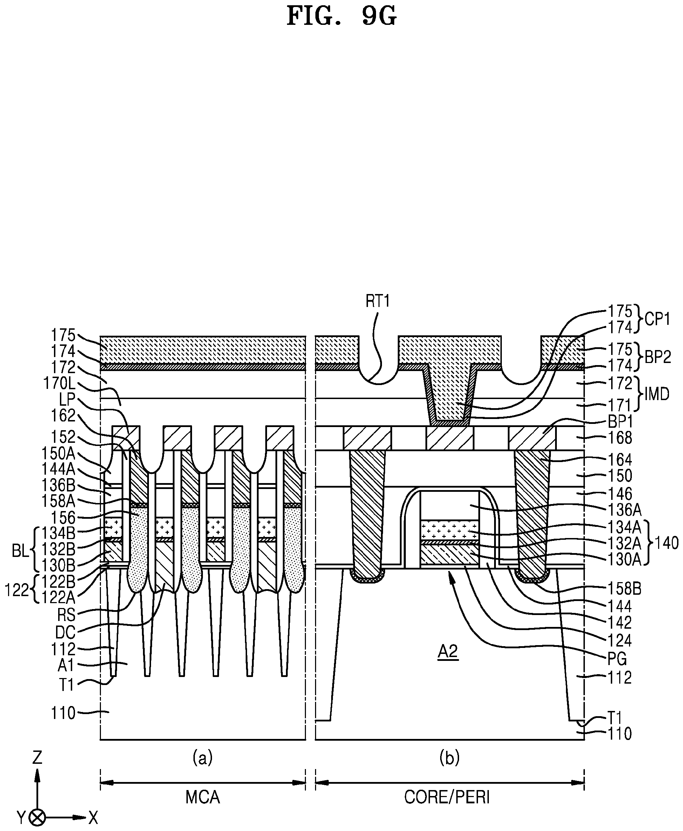

Referring to FIG. 9G, in the peripheral circuit area CORE/PERI of the resultant structure of FIG. 9F, the metal film 175 and the conductive barrier film 174 may be patterned to form a plurality of middle wiring patterns BP2 and a lower contact plug CP1. In this case, while the metal film 175 and the conductive barrier film 174 are being etched to pattern the metal film 175 and the conductive barrier film 174, the inter-wiring insulating film IMD may be partially etched due to an excessive etching process, and thus, a plurality of recessed top surfaces RT1 may be formed in a top surface of the inter-wiring insulating film IMD.

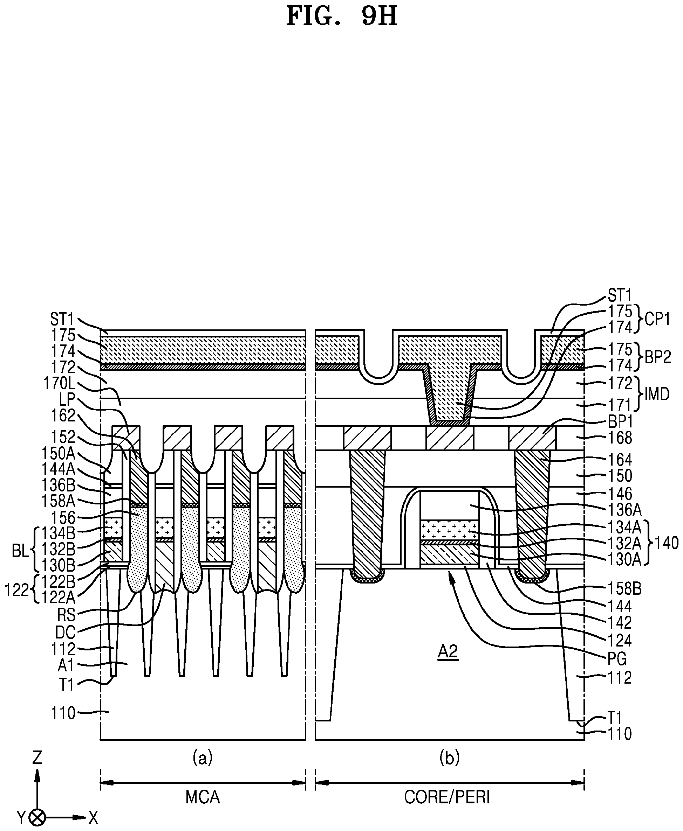

Referring to FIG. 9H, a first insulating liner ST1 conformally covering exposed surfaces may be formed in the resultant structure of FIG. 9G.

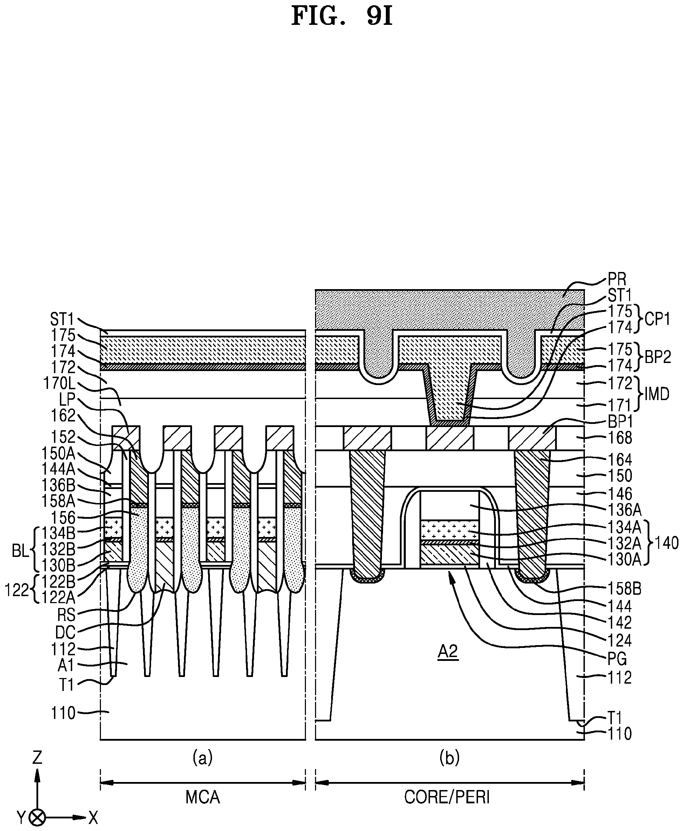

Referring to FIG. 9I, in the resultant structure of FIG. 9H, a photoresist pattern PR may be formed to cover the peripheral circuit area CORE/PERI. The cell array area MCA may not be covered by the photoresist pattern PR, and thus, the first insulating liner ST1 may be exposed in the cell array area MCA.

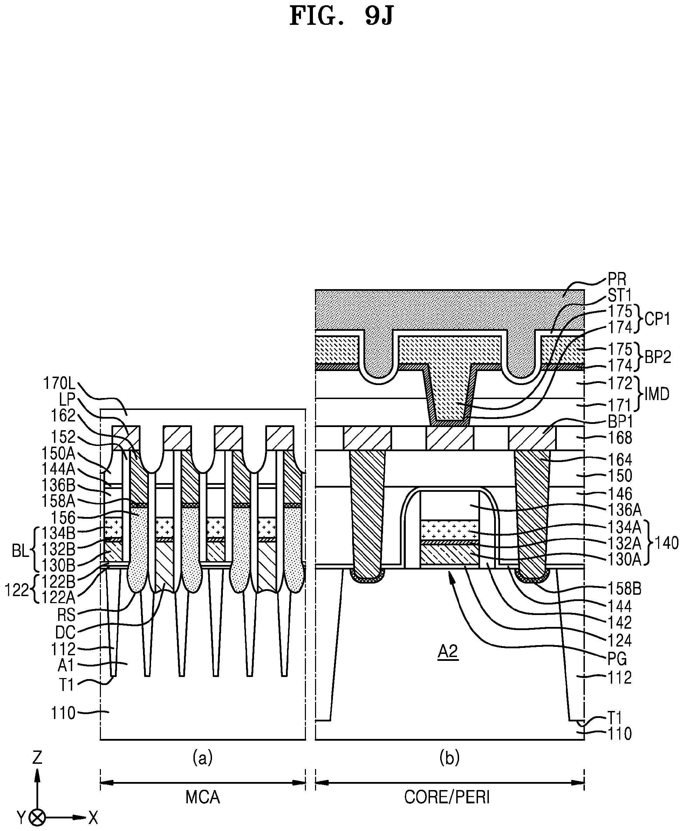

Referring to FIG. 9J, in the resultant structure of FIG. 9I, the first insulating liner ST1, the metal film 175, the conductive barrier film 174, and the second insulating film 172 may be removed from the exposed surface of the cell array area MCA by using the photoresist pattern PR as an etch mask, and thus, a top surface of the isolated insulating film 170L may be exposed. In this case, during an etching process of removing the second insulating film 172, the isolated insulating film 170L may also be consumed by a partial thickness from the top surface thereof, and thus, a thickness of the isolated insulating film 170L may be reduced.

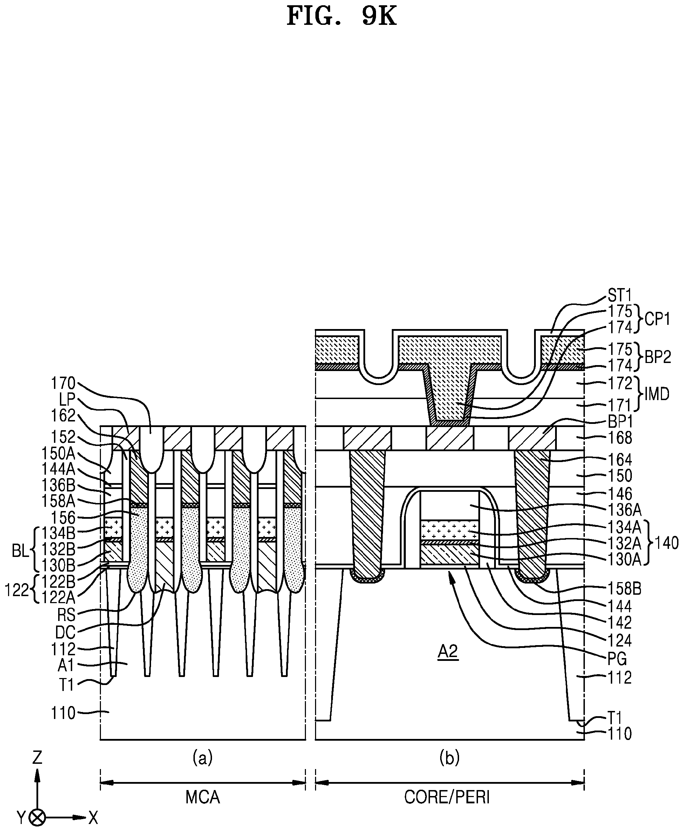

Referring to FIG. 9K, in the resultant structure of FIG. 9J, the isolated insulating film 170L remaining in the cell array area MCA may be etched back by a partial thickness from the top surface thereof, and thus, a top surface of each of the plurality of conductive landing pads LP may be exposed. As a result, an isolated insulating pattern 170 may be formed from the remaining portion of the isolated insulating film 170L in the cell array area MCA. Thereafter, the photoresist pattern PR may be removed using ashing and strip processes to expose the first insulating liner ST1 in the peripheral circuit area CORE/PERI.

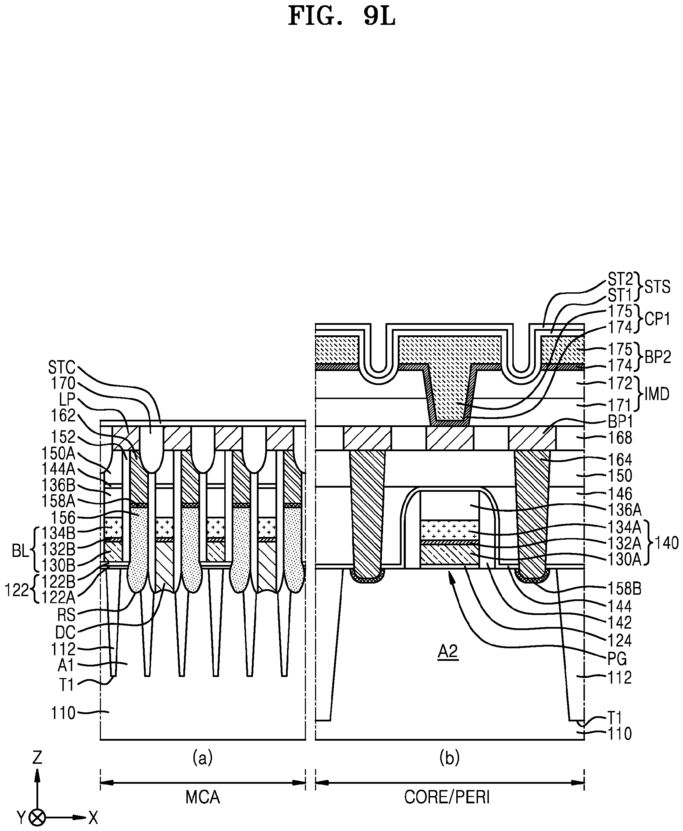

Referring to FIG. 9L, in the resultant structure of FIG. 9K, a cell protective insulating liner STC conformally covering exposed surfaces may be formed in the cell array area MCA, and a second insulating liner ST2 conformally covering exposed surfaces may be formed in the peripheral circuit area CORE/PERI. In the peripheral circuit area CORE/PERI, the first insulating liner ST1 and the second insulating liner ST2 may constitute a peripheral protective insulating liner STS. The cell protective insulating liner STC and the second insulating liner ST2 may include the same material and substantially have the same thickness. The cell protective insulating liner STC and the second insulating liner ST2 may be formed at the same time.

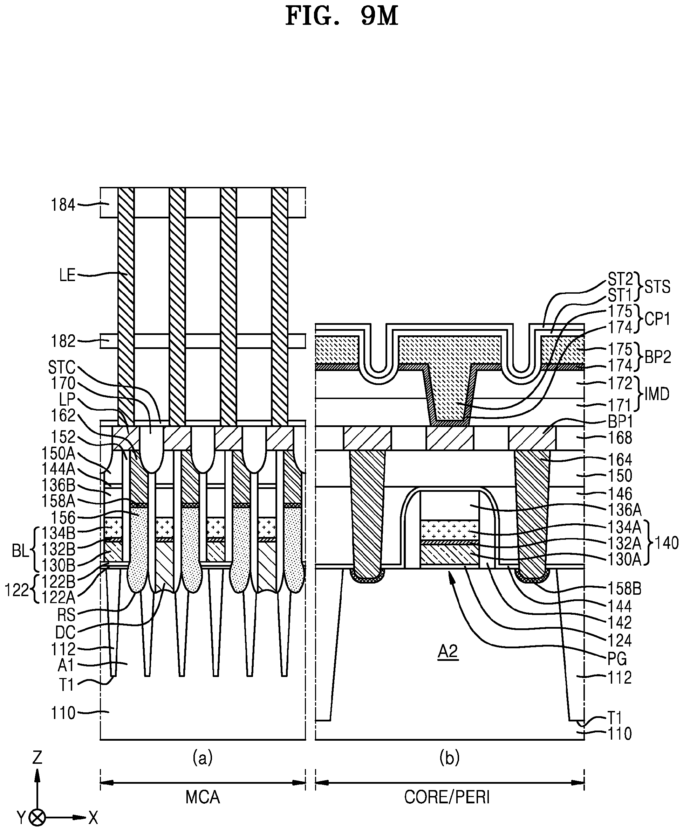

Referring to FIG. 9M, in the resultant structure of FIG. 9L, a plurality of lower electrodes LE and a lower support film 182 and an upper support film 184, which support the plurality of lower electrodes LE, may be formed in the cell array area MCA. Each of the plurality of lower electrodes LE may be formed to pass through the cell protective insulating liner STC and contact the conductive landing pad LP.

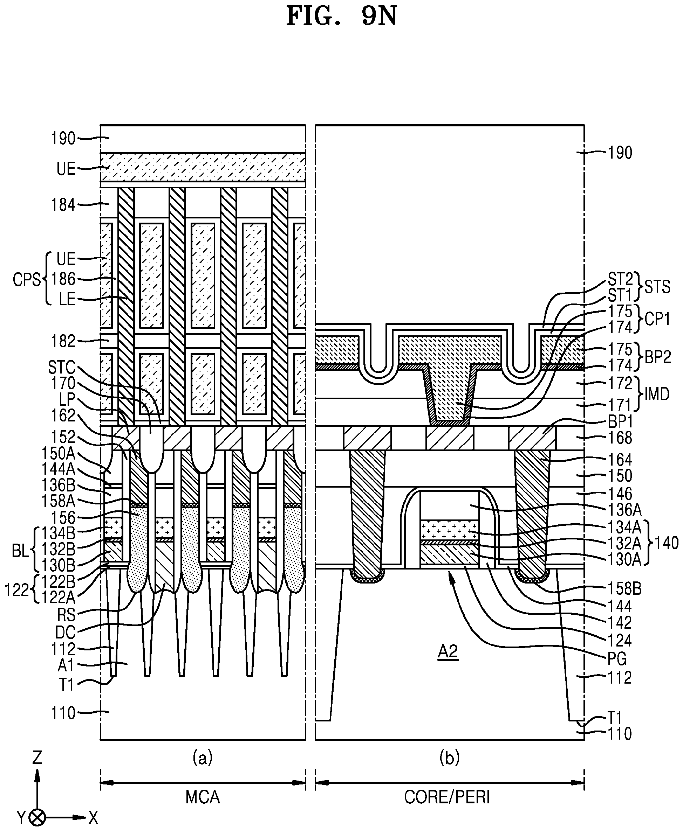

Referring to FIG. 9N, a dielectric film 186 conformally covering exposed surfaces and an upper electrode UE covering the plurality of lower electrodes LE on the dielectric film 186 may be formed in the resultant structure of FIG. 9M to form a capacitor structure CPS. Afterwards, an upper interlayer insulating film 190 may be formed to cover the capacitor structure CPS located in the cell array area MCA and the peripheral protective insulating liner STS located in the peripheral circuit area CORE/PERI.

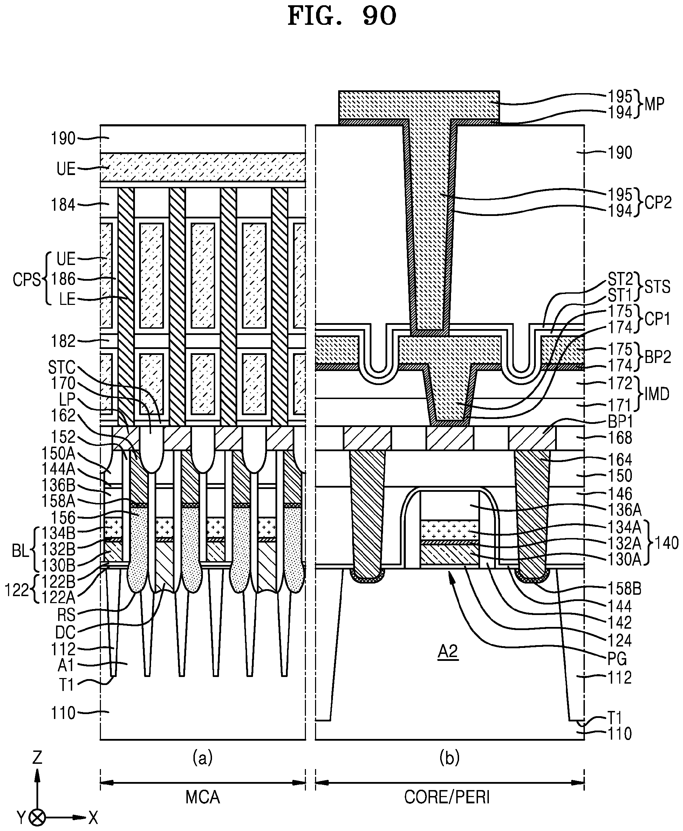

Referring to FIG. 9O, a contact hole passing through the upper interlayer insulating film 190 in a vertical direction (Z direction) may be formed in the peripheral circuit area CORE/PERI, and a conductive barrier film 194 and a metal film 195 may be formed inside the contact hole and on the upper interlayer insulating film 190. Also, the conductive barrier film 194 and the metal film 195, which are on the upper interlayer insulating film 190, may be patterned to form an upper wiring pattern MP and an upper contact plug CP2. Thus, the IC device 100 shown in FIGS. 4 and 5 may be manufactured.

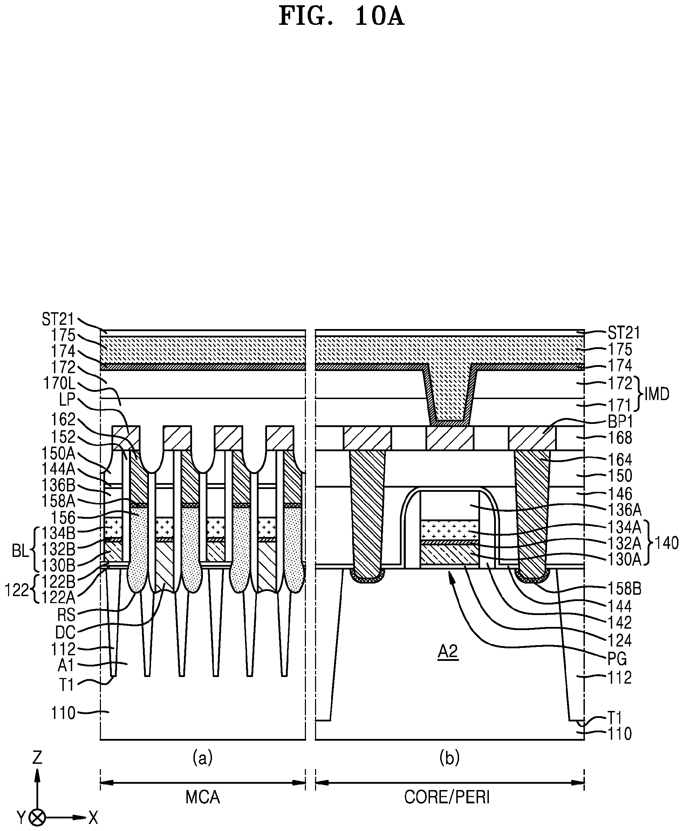

FIGS. 10A to 10D are cross-sectional views of a process sequence of a method of manufacturing an IC device, according to some example embodiments. An example of a method of manufacturing the IC device shown in FIGS. 6 and 7 is described with reference to FIGS. 10A to 10D. In FIGS. 10A to 10D, the same reference numerals are used to denote the same elements as in FIGS. 1 to 5, and thus, repeated descriptions thereof are omitted.

Referring to FIG. 10A, the processes described above with reference to FIGS. 8A to 8L and 9A to 9F may be performed. Thereafter, in the resultant structure of FIG. 9F, a first insulating liner ST21 conformally covering an exposed top surface of a metal film 175 may be formed in each of a cell array area MCA and a peripheral circuit area CORE/PERI.

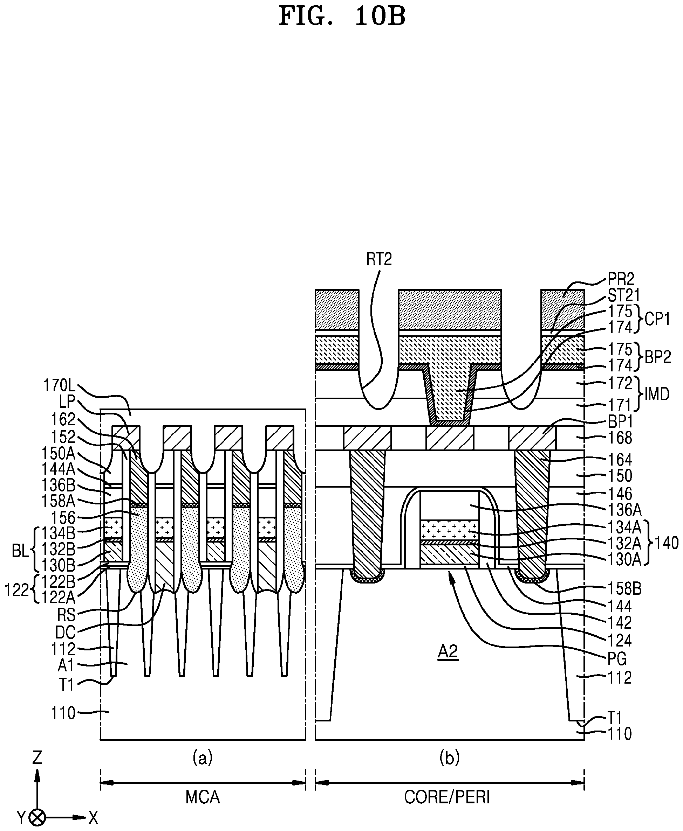

Referring to FIG. 10B, in the resultant structure of FIG. 10A, a photoresist pattern PR2 covering the first insulating liner ST21 may be formed in the peripheral circuit area CORE/PERI. The cell array area MCA may not be covered by the photoresist pattern PR2, and a partial region of the first insulating liner ST21 may be exposed through the photoresist pattern PR2 in the peripheral circuit area CORE/PERI.

Thereafter, the first insulating liner ST21, the metal film 175, the conductive barrier film 174, and the second insulating film 172 may be removed from an exposed surface of the cell array area MCA by using the photoresist pattern PR2 as an etch mask to expose a top surface of the isolated insulating film 170L. In this case, during the process of etching the second insulating film 172, the isolated insulating film 170L may also be consumed by a partial thickness from the top surface of the isolated insulating film 170L, and thus, a thickness of the isolated insulating film 170L may be reduced.

In the peripheral circuit area CORE/PERI, the first insulating liner ST21, the metal film 175, and the conductive barrier film 174 may be patterned by using the photoresist pattern PR2 as an etch mask, and thus, a plurality of middle wiring patterns BP2 and a lower contact plug CP1 may be formed. In this case, while the metal film 175 and the conductive barrier film 174 are being etched to pattern the metal film 175 and the conductive barrier film 174, the inter-wiring insulating film IMD may be partially etched due to an excessive etching process, and thus, a plurality of recessed top surfaces RT2 may be formed in a top surface of the inter-wiring insulating film IMD.

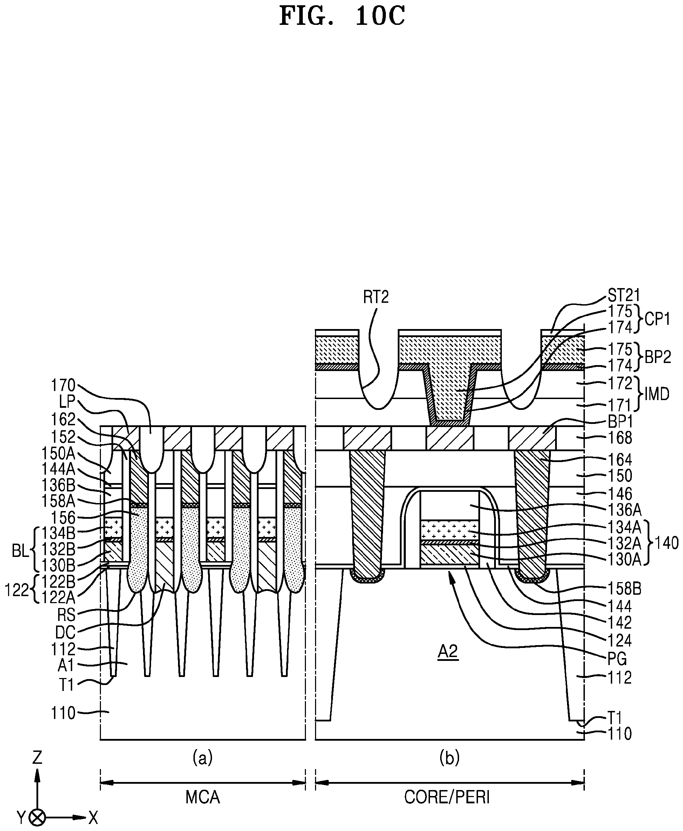

Referring to FIG. 10C, in the resultant structure of FIG. 10B, the isolated insulating film 170L remaining in the cell array area MCA may be etched back by a partial thickness from the top surface thereof, and thus, a top surface of each of a plurality of conductive landing pads LP may be exposed. As a result, in the cell array area MCA, an isolated insulating pattern 170 may be formed from the remaining portion of the isolated insulating film 170L. Thereafter, the photoresist pattern PR2 may be removed by using ashing and strip processes to expose the first insulating liner ST21 in the peripheral circuit area CORE/PERI.

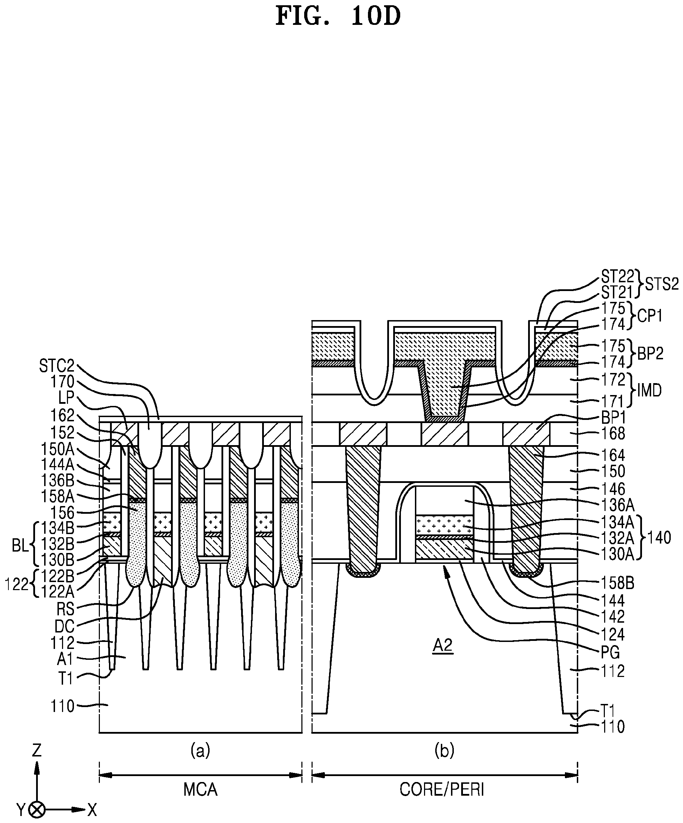

Referring to FIG. 10D, in the resultant structure of FIG. 10C, a cell protective insulating liner STC2 conformally covering exposed surfaces may be formed in the cell array area MCA, and a second insulating liner ST22 conformally covering exposed surfaces may be formed in the peripheral circuit area CORE/PERI. In the peripheral circuit area CORE/PERI, the first insulating liner ST21 and the second insulating liner ST22 may constitute a peripheral protective insulating liner STS2. The cell protective insulating liner STC2 and the second insulating liner ST22 may include the same material and substantially have the same thickness. The cell protective insulating liner STC2 and the second insulating liner ST22 may be formed at the same time.

Thereafter, processes similar to those described with reference to FIGS. 9M to 9O may be performed on the resultant structure of FIG. 10D, and thus, the IC device 200 described with reference to FIGS. 6 and 7 may be manufactured.

Any of the elements and/or functional blocks disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc. The processing circuitry may include electrical components such as at least one of transistors, resistors, capacitors, etc. The processing circuitry may include electrical components such as logic gates including at least one of AND gates, OR gates, NAND gates, NOT gates, etc.

Embodiments are set out in the following Clauses:
Clause 1. An integrated circuit device comprising:
   a substrate having a cell array area and a peripheral circuit area including a core area, the peripheral circuit area adjacent to the cell array area;
   a plurality of cell conductive patterns in the cell array area on the substrate, the plurality of cell conductive patterns at a reference vertical level;
   a plurality of lower wiring patterns in the peripheral circuit area, the plurality of lower wiring patterns at the reference vertical level;
   a capacitor structure in the cell array area, the capacitor structure including a plurality of lower electrodes connected to the plurality of cell conductive patterns, respectively;
   a middle wiring pattern in the peripheral circuit area, the middle wiring pattern at a first vertical level that is farther from the substrate than the reference vertical level and closer to the substrate than a vertical level of an uppermost surface of the substrate of the capacitor structure;
   a cell protective insulating liner in the cell array area, the cell protective insulating liner covering a top surface of each of the plurality of cell conductive patterns; and
   a peripheral protective insulating liner in the peripheral circuit area, the peripheral protective insulating liner covering a surface of the middle wiring pattern, wherein
   at least a portion of the peripheral protective insulating liner has a thickness greater than a thickness of the cell protective insulating liner.
Clause 2. The integrated circuit device of Clause 1, wherein
   the cell protective insulating liner has a single layer structure comprising a single insulating liner, and
   the peripheral protective insulating liner has a multilayered structure comprising a plurality of insulating liners.
Clause 3. The integrated circuit device of Clause 1 or Clause 2, wherein the middle wiring pattern is connected to a selected one of the plurality of lower wiring patterns.
Clause 4. The integrated circuit device of any preceding Clause, wherein the peripheral protective insulating liner comprises:
   a first insulating liner contacting a top surface and sidewalls of the middle wiring pattern; and
   a second insulating liner covering the top surface and the sidewalls of the middle wiring pattern, the second insulating liner being apart from the middle wiring pattern with the first insulating liner between the second insulating liner and the middle wiring pattern.
Clause 5. The integrated circuit device of any of Clauses 1-3, wherein the peripheral protective insulating liner comprises:
   a first insulating liner contacting a top surface of the middle wiring pattern; and
   a second insulating liner covering the top surface and sidewalls of the middle wiring pattern, the second insulating liner being apart from the top surface of the middle wiring pattern with the first insulating liner between the second insulating liner and the top surface of the middle wiring pattern, and the second insulating liner contacting the sidewalls of the middle wiring pattern.
Clause 6. The integrated circuit device of any preceding Clause, further comprising:
   an isolated insulating pattern in the cell array area, the isolated insulating pattern filling a space between two adjacent ones of the plurality of cell conductive patterns,
   wherein the cell protective insulating liner comprises portions contacting the plurality of lower electrodes and a portion between a top surface of the isolated insulating pattern and the capacitor structure.
Clause 7. The integrated circuit device of any preceding Clause, further comprising:
   an upper wiring pattern in the peripheral circuit area, the upper wiring pattern at a second vertical level that is farther from the substrate than a vertical level of the uppermost surface of the capacitor structure,
   wherein the upper wiring pattern passes through the peripheral protective insulating liner and is connected to the middle wiring pattern.
Clause 8. The integrated circuit device of any preceding Clause, further comprising:
   an inter-wiring insulating film in the peripheral circuit area, the inter-wiring insulating film between the plurality of lower wiring patterns and the middle wiring pattern,
   wherein the peripheral protective insulating liner continuously extends from above the surface of the middle wiring pattern to above a top surface of the inter-wiring insulating film to contact the top surface of the inter-wiring insulating film.
Clause 9. The integrated circuit device of any preceding Clause, wherein each of the cell protective insulating liner and the peripheral protective insulating liner comprises a silicon boron nitride (SiBN) film, a silicon nitride (SiN) film, a silicon carbonitride (SiCN) film, or a combination thereof.
Clause 10. An integrated circuit device comprising:
   a substrate having a cell array area and a peripheral circuit area including a core area, the peripheral circuit area adjacent to the cell array area;
   a bit line on the substrate in the cell array area;
   a cell contact plug apart from the bit line in a lateral direction in the cell array area, the cell contact plugs being connected to a cell active area of the substrate;
   a conductive landing pad contacting the cell contact plug, the conductive landing pad on the cell contact plug in the cell array area, the conductive landing pad being at a reference vertical level on the substrate;
   an isolated insulating pattern in the cell array area, the isolated insulating pattern covering sidewalls of the conductive landing pad;
   a plurality of lower wiring patterns in the peripheral circuit area, the plurality of lower wiring patterns at the reference vertical level;
   a capacitor structure in the cell array area, the capacitor structure including a lower electrode connected to the conductive landing pad;
   a plurality of middle wiring patterns in the peripheral circuit area, the plurality of middle wiring patterns at a first vertical level that is farther from the substrate than the reference vertical level and closer to the substrate than a vertical level of an uppermost surface of the capacitor structure, the plurality of middle wiring patterns being apart from each other in the lateral direction;
   a cell protective insulating liner covering a top surface of each of the conductive landing pad and the isolated insulating pattern; and
   a peripheral protective insulating liner covering a surface of each of the plurality of middle wiring patterns,
   wherein at least a portion of the peripheral protective insulating liner has a thickness greater than a thickness of the cell protective insulating liner.
Clause 11. The integrated circuit device of Clause 10, further comprising:
   an upper wiring pattern in the peripheral circuit area, the upper wiring pattern at a second vertical level that is farther from the substrate than the vertical level of the uppermost surface of the capacitor structure; and
   an upper contact plug extending in a vertical direction between a selected one of the plurality of middle wiring patterns and the upper wiring pattern, the upper contact plug contacting each of the upper wiring pattern and the middle wiring patterns,
   wherein, in the cell array area, the lower electrode passes through the cell protective insulating liner in the vertical direction and contacts the conductive landing pad, and,
   in the peripheral circuit area, the upper contact plug passes through the peripheral protective insulating liner in the vertical direction and contacts the selected one of the plurality of middle wiring patterns.
Clause 12. The integrated circuit device of Clause 10 or Clause 11, wherein
   the cell protective insulating liner has a single layer structure comprising a single insulating liner, and
   the peripheral protective insulating liner includes a first insulating liner and a second insulating liner, which are sequentially stacked on a surface of each of the plurality of middle wiring patterns,
   wherein each of the cell protective insulating liner, the first insulating liner, and the second insulating liner includes a silicon boron nitride (SiBN) film, a silicon nitride (SiN) film, a silicon carbonitride (SiCN) film, or a combination thereof.
Clause 13. The integrated circuit device of any of Clauses 10-12, wherein the peripheral protective insulating liner comprises:
   a first insulating liner contacting a top surface and sidewalls of each of the plurality of middle wiring patterns; and
   a second insulating liner covering the top surface and the sidewalls of each of the plurality of middle wiring patterns, the second insulating liner being apart from the middle wiring patterns with the first insulating liner between the second insulating liner and the middle wiring patterns.
Clause 14. The integrated circuit device of any of Clauses 10-12, wherein the peripheral protective insulating liner comprises:
   a first insulating liner contacting a top surface of each of the plurality of middle wiring patterns; and
   a second insulating liner covering the top surface and sidewalls of the plurality of middle wiring patterns, the second insulating liner being apart from the top surface of each of the plurality of middle wiring patterns with the first insulating liner between the second insulating pattern and the top surface of each of the plurality of middle wiring patterns, and the second insulating liner contacting the sidewalls of each of the plurality of middle wiring patterns.
Clause 15. The integrated circuit device of any of Clauses 10-14, further comprising:
   an inter-wiring insulating film in the peripheral circuit area, the inter-wiring insulating film between the plurality of lower wiring patterns and the plurality of middle wiring patterns,
   wherein the inter-wiring insulating film includes a plurality of recessed top surfaces each being between two adjacent ones of the plurality of middle wiring patterns,
   the peripheral protective insulating liner includes a plurality of curved portions that respectively conformally contact the plurality of recessed top surfaces of the inter-wiring insulating film and convexly extend toward the substrate.

While the inventive concepts have been particularly shown and described with reference to some example embodiments thereof, it will be understood that various changes in form and details may be made therein without departing from the scope of the following claims.

## Claims

1. An integrated circuit device comprising:
a substrate having a cell array area and a peripheral circuit area including a core area, the peripheral circuit being area adjacent to the cell array area;
a plurality of cell conductive patterns in the cell array area on the substrate, the plurality of cell conductive patterns at a reference vertical level;
a plurality of lower wiring patterns in the peripheral circuit area, the plurality of lower wiring patterns being at the reference vertical level;
a capacitor structure in the cell array area, the capacitor structure including a plurality of lower electrodes connected to the plurality of cell conductive patterns, respectively;
a middle wiring pattern in the peripheral circuit area, the middle wiring pattern being at a first vertical level that is farther from the substrate than the reference vertical level and closer to the substrate than a vertical level of an uppermost surface of the capacitor structure;
a cell protective insulating liner in the cell array area, the cell protective insulating liner covering a top surface of each of the plurality of cell conductive patterns; and
a peripheral protective insulating liner in the peripheral circuit area, the peripheral protective insulating liner covering a surface of the middle wiring pattern, wherein
at least a portion of the peripheral protective insulating liner has a thickness greater than a thickness of the cell protective insulating liner.

2. The integrated circuit device of claim 1, wherein
the cell protective insulating liner has a single layer structure comprising a single insulating liner, and
the peripheral protective insulating liner has a multilayered structure comprising a plurality of insulating liners.

3. The integrated circuit device of claim 1 or claim 2, wherein the middle wiring pattern is connected to a selected one of the plurality of lower wiring patterns.

4. The integrated circuit device of any preceding claim, wherein the peripheral protective insulating liner comprises:
a first insulating liner contacting a top surface and sidewalls of the middle wiring pattern; and
a second insulating liner covering the top surface and the sidewalls of the middle wiring pattern, the second insulating liner being apart from the middle wiring pattern with the first insulating liner between the second insulating liner and the middle wiring pattern.

5. The integrated circuit device of any of claims 1-3, wherein the peripheral protective insulating liner comprises:
a first insulating liner contacting a top surface of the middle wiring pattern; and
a second insulating liner covering the top surface and sidewalls of the middle wiring pattern, the second insulating liner being apart from the top surface of the middle wiring pattern with the first insulating liner between the second insulating liner and the top surface of the middle wiring pattern, and the second insulating liner contacting the sidewalls of the middle wiring pattern.

6. The integrated circuit device of any preceding claim, further comprising:
an isolated insulating pattern in the cell array area, the isolated insulating pattern filling a space between two adjacent ones of the plurality of cell conductive patterns,
wherein the cell protective insulating liner comprises portions contacting the plurality of lower electrodes and a portion between a top surface of the isolated insulating pattern and the capacitor structure.

7. The integrated circuit device of any preceding claim, further comprising:
an upper wiring pattern in the peripheral circuit area, the upper wiring pattern being at a second vertical level that is farther from the substrate than the vertical level of the uppermost surface of the capacitor structure,
wherein the upper wiring pattern passes through the peripheral protective insulating liner and is connected to the middle wiring pattern.

8. The integrated circuit device of any preceding claim, further comprising:
an inter-wiring insulating film in the peripheral circuit area, the inter-wiring insulating film being between the plurality of lower wiring patterns and the middle wiring pattern,
wherein the peripheral protective insulating liner continuously extends from above the surface of the middle wiring pattern to above a top surface of the inter-wiring insulating film to contact the top surface of the inter-wiring insulating film.

9. The integrated circuit device of any preceding claim, wherein each of the cell protective insulating liner and the peripheral protective insulating liner comprises a silicon boron nitride film, a silicon nitride film, a silicon carbonitride film, or a combination thereof.

10. An integrated circuit device according to any preceding claim further comprising:
a bit line on the substrate in the cell array area;
a cell contact plug apart from the bit line in a lateral direction in the cell array area, the cell contact plug being connected to a cell active area of the substrate; and
an isolated insulating pattern in the cell array area,
wherein one of the plurality of cell conductive patterns is a conductive landing pad contacting the cell contact plug, the conductive landing pad being on the cell contact plug in the cell array area,
wherein the isolated insulating pattern covers sidewalls of the conductive landing pad,
wherein the middle wiring pattern is one of a plurality of middle wiring patterns in the peripheral circuit area, the plurality of middle wiring patterns being at the first vertical level, the plurality of middle wiring patterns being apart from each other in the lateral direction,
wherein the cell protective insulating liner covers a top surface of each of the conductive landing pad and the isolated insulating pattern, and
wherein the peripheral protective insulating liner covers a surface of each of the plurality of middle wiring patterns.

11. The integrated circuit device of claim 10, further comprising:
an upper wiring pattern in the peripheral circuit area, the upper wiring pattern being at a second vertical level that is farther from the substrate than the vertical level of the uppermost surface of the capacitor structure; and
an upper contact plug extending in a vertical direction between a selected one of the plurality of middle wiring patterns and the upper wiring pattern, the upper contact plug contacting each of the upper wiring pattern and the selected one of the middle wiring patterns,
wherein, in the cell array area, the lower electrode passes through the cell protective insulating liner in the vertical direction and contacts the conductive landing pad, and,
in the peripheral circuit area, the upper contact plug passes through the peripheral protective insulating liner in the vertical direction and contacts the selected one of the plurality of middle wiring patterns.

12. The integrated circuit device of claim 10 or claim 11, further comprising:
an inter-wiring insulating film in the peripheral circuit area, the inter-wiring insulating film between the plurality of lower wiring patterns and the plurality of middle wiring patterns,
wherein the inter-wiring insulating film includes a plurality of recessed top surfaces each being between two adjacent ones of the plurality of middle wiring patterns,
the peripheral protective insulating liner includes a plurality of curved portions that respectively conformally contact the plurality of recessed top surfaces of the inter-wiring insulating film and convexly extend toward the substrate.
